# EUROPEAN PATENT APPLICATION

(11) **EP 4 625 781 A2**
(43) Date of publication of application: **01.10.2025**
(21) Application number: 25180448.0
(22) Date of filing: 24.04.2020
(51) Int. Cl.: H02K 11/33

(54) **ELECTRIC DRIVE MODULE**

(30) Priority: 25.04.2019 US 201962838893 P; 23.09.2019 US 201962904199 P
(62) Divisional of application: 20795936.2
(71) Applicant: American Axle & Manufacturing, Inc., Detroit, MI 48211 (US)
(72) Inventor: Downs, James P., South Lyon, MI 48178 (US); Crecelius, David, Cicero, IN 46034 (US); Ronning, Jeffrey, Grosse Pointe Farms, MI 48236 (US); Valente, Paul J., Berkley, MI 48072 (US); Morgante, John C., Sterling Heights, MI 48207 (US)
(74) Representative: Bird & Bird LLP - Hamburg

(57) **Abstract**

Described is an electric drive unit comprising a stator having a stator body and a plurality of sets of field windings. The stator body defines a plurality of cooling channels that extend longitudinally through the stator body. The electric drive unit also comprises a rotor received in the stator, and an inverter assembly that includes a plurality of MOSFETs, a plurality of heat sinks and an end plate, each of the power MOSFETs being thermally coupled to a corresponding one of the heat sinks, each of the heat sinks having a plurality of fins that extend into a flow channel, the end plate being fixedly coupled to the power semiconductors and having a projection and a coolant inlet port, the projection being coupled to the field windings and defining an annular cavity, the coolant port being coupled in fluid communication with the annular cavity, wherein the flow channel is in fluid communication with and disposed in a flow path between the annular cavity and the cooling channels in the stator body.

## Description

### CROSS-REFERENCE TO RELATED APPLICATIONS

This application claims the benefit of U.S. Provisional Application No. 62/838,893 filed April 25, 2019 and U.S. Provisional Application No. 62/904,199 filed September 23, 2019, the disclosures of which are incorporated by reference as fully set forth in detail herein.

### FIELD

The present disclosure relates to an electric drive module.

### BACKGROUND

This section provides background information related to the present disclosure which is not necessarily prior art.

While there is increasing interest in the electrification of vehicle drivelines, there are significant issues that must be overcome before vehicles with electrified drivelines substantially displace vehicle drivelines that are powered solely by internal combustion engines. Some of these issues include the cost of the electrified driveline, the volume of the electrified driveline and its ability to be packaged into available space within a vehicle, as well as the robustness of the electronics that are employed to operate and control the electrified driveline.

### SUMMARY

This section provides a general summary of the disclosure, and is not a comprehensive disclosure of its full scope or all of its features.

In one form, the present disclosure provides a motor assembly having an inverter with a plurality of transistor assemblies. Each of the transistor assemblies can include a surface mount MOSFET, a heat sink, and a solder material. The MOSFET has a plurality of blade terminals and a surface mount terminal that is electrically coupled to one of the blade terminals. The heat sink has a base and a plurality of fins that extend from the base. The base defines a pocket having a bottom surface. The MOSFET is received into the pocket such that the surface mount terminal is disposed proximate the bottom surface. The solder material thermally coupling the surface mount terminal to the heat sink.

In some forms, the invertor also includes a retainer that fixedly couples the MOSFETS and the heat sinks to one another. The retainer can be cohesively bonded to the MOSFETS and the heat sinks. Optionally, the solder material has a melting point that is low enough to permit the solder material to melt when the motor assembly is operated at a predetermined power load for a predetermined time interval. Optionally, the retainer forms a seal between each of the MOSFETS and each of the heat sinks that inhibits migration of the solder material out of the pocket when the solder material melts.

In some forms, the solder material is at least partly formed of indium.

In some forms, one of the MOSFET and the heat sink of each transistor assembly is formed with a feature that provides clearance between the MOSFET and the heat sink to permit air to vent from between the surface mount power terminal and the bottom surface. Optionally, the feature can include a tapered wall on the heat sink that defines at least a portion of the pocket.

In another forms, the present disclosure provides a method for mitigating solder fatigue in an inverter of an electric motor. The method includes: providing a surface mount MOSFET having a plurality of blade terminals and a surface mount terminal that is electrically coupled to one of the blade terminals; providing a heat sink having a base and a plurality of fins that extend from the base, the base defining a pocket having a bottom surface; placing a solder material adjacent the bottom surface; placing the MOSFET into the pocket such that the solder material is disposed between the surface mount power terminal and the bottom surface; melting the solder material to bond the surface mount power terminal to the heat sink; operating the motor assembly to generate heat in the inverter that is sufficient to cause the solder material to melt; and cooling the solder material to cause the solder material to re-bond to the surface mount power terminal to the heat sink.

In still another form, the present disclosure provides a motor assembly that includes a stator, a rotor and a control unit. The stator has a plurality of field windings. The rotor is received in the stator and is rotatable about a rotary axis. The control unit has an inverter and a controller. The inverter is electrically coupled to the field windings. The controller includes a circuit board assembly and a magnet. The circuit board assembly is coupled to the stator and has a tunnel magneto resistive (TMR) sensor that is configured to sense a rotational position of the magnet about the rotary axis and responsively generate a sensor signal. The controller is configured to control the inverter to power the field windings responsive to the sensor signal.

In yet another form, the present disclosure provides an electric drive unit that includes a stator and an inverter assembly. The stator has a stator body and a plurality of field windings. The stator body defines a plurality of cooling channels that extend longitudinally through the stator body. The field windings are fixedly coupled to the stator body and are circumferentially spaced apart about a central longitudinal axis. The inverter assembly includes a plurality of MOSFET's, a plurality of heat sinks and an end plate. Each of the MOSFET's is thermally coupled to a corresponding one of the heat sinks. Each of the heat sinks having a plurality of fins that extend into a flow channel that is coaxial with the field windings and disposed radially between the field windings and the MOSFET's. The end plate is fixedly coupled to the MOSFET's and has a tubular central projection and a coolant inlet port. The tubular central projection is sealingly coupled to the field windings such that an annular cavity is formed radially between a radially outer surface of the tubular central projection and an interior circumferential surface of the field windings. The coolant inlet port intersects the annular cavity. An annular gap is formed axially between the end plate and an axial end of the field windings. A radially inward end of the annular gap intersects the annular cavity, while a radially outward end of the annular gap intersects the flow channel.

In a further form, the present disclosure provides an electric drive module that includes a housing assembly, a differential assembly, a differential bearing, a stator and a rotor. The housing assembly has a first housing and a second housing. The differential assembly is received in the first housing and includes a differential case that is rotatable about a differential axis. The differential bearing is received in the first housing and supports the differential case for rotation relative to the housing assembly. The stator is received in the second housing and defines a plurality of cooling channels that are formed longitudinally through the stator. The rotor is received in the stator and is rotatable about a rotor axis. A lubrication gallery is formed into an axial end of one of the first and second housings. The lubrication gallery has a first end, which is in fluid communication with the cooling channels in the stator, and a second end that is in fluid communication with the differential bearing.

In some forms, the electric drive module further includes an output shaft, the differential assembly includes a gearset with a side gear, the output shaft is coupled to the side gear for rotation therewith, and lubrication exiting the second end of the lubrication gallery is configured to drain onto the output shaft. A first portion of the lubricant that drains onto the output shaft is directed toward the side gear to lubricate the gearset, while a second portion of the lubricant that drains onto the output shaft is directed away from the side gear toward a shaft bearing that supports the output shaft relative to the housing assembly for rotation about the differential axis.

In another form, the present disclosure provides an electric drive module that includes a motor and an inverter. The motor has a stator and a rotor that is rotatably disposed in the stator for rotation about a rotary axis. The stator has a plurality of field windings that are spaced circumferentially about the rotary axis. The inverter has a circuit board assembly, a plurality of MOSFET's and a plurality of heat sinks. The circuit board assembly has a circuit board, which has an annular portion that is disposed concentrically about the rotor, and a plurality of power terminals. Each of the MOSFET's has a plurality of terminals that are received through and electrically coupled to the circuit board assembly. The MOSFET's are disposed in a circular arrangement. Each of the heat sinks is thermally coupled to an associated one of the MOSFET's and are disposed concentrically within the MOSFET's.

In some forms, the inverter includes a retainer that is coupled to the MOSFET's and disposed concentrically about the MOSFET's. The electric drive module can include an end plate that is coupled to the MOSFET's and the heat sinks, and which can be disposed axially between the heat sinks and the circuit board assembly. Optionally, The electric drive module can further include a plurality of phase leads, and the end plate can define a plurality of phase lead bosses. Each of the phase leads can be received through an associated one of the phase lead bosses and can be electrically coupled to an associated set of the field windings. Optionally, the end plate can have a tubular central projection that is sealingly engaged to the field windings.

Optionally, the electric drive module can further include a housing in which the motor and inverter are received. The retainer can be sealingly engaged to the housing. Optionally, the retainer is cohesively bonded to the MOSFET's.

Optionally, the electric drive module can further include a field capacitor, a first bus bar, a second bus bar, a first insulator, a second insulator, a third insulator, and a plurality of conductor plates. The field capacitor has a set of first capacitor leads and a set of second capacitor leads. The first bus bar is electrically coupled to the first set of capacitor leads and has a first annular portion that is concentric with the circuit board. The first bus bar is electrically coupled to a terminal on each of a first powering set of the MOSFET's. The second bus bar is electrically coupled to the second set of capacitor leads and has a second annular portion that is concentric with the circuit board. The second bus bar is electrically coupled to a terminal on each of a second powering set of the MOSFET's. The first insulator is disposed between the conductor plates and the first bus bar. The second insulator is disposed between the first and second bus bars. The third insulator being disposed between the circuit board and the second bus bar. Each of the conductor plates being electrically coupled to a power output terminal on each of a plurality of the MOSFET's that control power to an associated set of the field windings.

Optionally, the electric drive unit can include a plurality of receivers. Each of the receivers is electrically coupled to an associated one of the conductor plates and is formed of a plurality of bident-shaped conductive members. Each of the bident-shaped conductive members has a pair of tines that cooperate to form an opening, and each set of the field windings has a blade terminal that is received in the opening and engaged to the tines of the bident-shaped conductive members of an associated one of the receivers.

Optionally, the electric drive unit can include a plurality of current sensors. Each of the current sensors has a plurality of current sensor laminations, which are disposed proximate a corresponding one of the conductor plates, and a Hall-effect sensor that is electrically coupled to the circuit board assembly and configured to sense a magnetic field in the plurality of current sensor laminations. Optionally, each of the current sensor laminations is C-shaped having a pair of opposing end faces, the first insulator defines a plurality of current sensor lamination mounts and a plurality of sensor mounts, each of the current sensor lamination mounts is configured to receive the current sensor laminations of a corresponding one of the current sensors thereon such that the opposing end faces are disposed on opposite sides of the sensor mount, and the sensor mount is disposed between the opposing end faces. The Hall-effect sensor is disposed on the sensor mount. Optionally, the first insulator defines a plurality of guide tubes, and each of the guide tubes is disposed about a corresponding one of the sensor mounts and shrouds a set of terminals of an associated one of the Hall-effect sensors. Optionally, the electric drive unit further includes a plurality of insulating members, each of which being disposed between the current sensor laminations of one of the current sensors and a corresponding one of the conductor plates.

In a further form, the present disclosure provides an electric drive module that includes a housing, a motor, a transmission, a differential assembly, a pair of shafts and an oil pump. The housing defines a pump mount. The motor is received in the housing and has a stator, a rotor and an inverter. The stator has a plurality of windings that are disposed circumferentially about a first axis. The stator defines a plurality of coolant passages that extend longitudinally through the stator. The rotor is received in the stator and is rotatable about the first axis. The inverter has a plurality of MOSFET's, a plurality of heat sinks and an end plate. The heat sinks are disposed concentrically about the field windings. Each of the MOSFET's being thermally coupled to an associated one of the heat sinks. The end plate being coupled to the MOSFET's and the heat sinks and being offset in an axial direction along the first axis from the field windings to form a first flow channel between an axial end of the field windings and the end plate. The transmission is received in the housing and has an input gear, which is driven by the rotor for rotation about the first axis, and an output gear that is rotatable about a second axis that is parallel to the first axis. The differential assembly is received in the housing and has a differential input, which is coupled to the output gear for rotation about the second axis, and a pair of differential output members. Each of the shafts is coupled to an associated one of the differential output members for rotation therewith. The oil pump is mounted to the pump mount and provides a flow of pressurized oil. A first portion of the flow of oil is routed through the first flow channel, and travels through the heat sinks and the coolant passages to cool the inverter and the stator, while a second portion of the flow of oil is routed through the rotor to cool the rotor.

In some forms, the electric drive module includes a heat exchanger and an oil filter, the housing defines a heat exchanger base and a filter mount. The heat exchanger is mounted to the heat exchanger base and the oil filter is mounted to the filter mount. Optionally, the entirety of the flow of pressurized oil flows through the heat exchanger and/or the entirety of the flow of pressurized oil flows through the oil filter.

In some forms, the electric drive unit includes a differential bearing that supports the differential input for rotation about the second axis relative to the housing. The differential bearing is in fluid communication with outlets of the coolant passages in the stator.

In some forms, the differential assembly includes a differential gearset that is in fluid communication with the differential bearing.

In some forms, the electric drive unit includes a shaft bearing that supports one of the shafts for rotation about the second axis relative to the housing, and the shaft bearing is in fluid communication with the differential bearing.

In some forms, the electric drive unit includes a rotor bearing that supports the rotor for rotation about the first axis relative to the housing, and the rotor bearing is in fluid communication with outlets of the coolant passages in the stator.

In some forms, the the housing includes a feed pipe that fluidly couples a central coolant passage in the rotor to the oil pump. Optionally, the feed pipe extends through the input gear of the transmission. Optionally, at least a portion of the oil that exits the central coolant passage in the rotor is re-directed to flow concentrically about the central coolant passage toward the feed pipe. Optionally, the oil that exits the rotor concentrically about the central coolant passage is directed to lubricate a plurality of gears of the transmission and a plurality of bearings that support the gears of the transmission for rotation about respective gear axes. Optionally, a portion of the oil that exits the central coolant passage is routed to lubricate a rotor bearing that supports the rotor for rotation relative to the housing.

In some forms, the inverter includes a circuit board assembly, which is electrically coupled to the MOSFET's, and a field capacitor that is electrically coupled to the circuit board assembly, while the housing defines a field capacitor cavity that houses the field capacitor cavity. The field capacitor cavity is coupled in fluid communication with the oil pump. Optionally, the field capacitor cavity is in fluid communication with the coolant passages in the stator. Optionally, oil exiting the field capacitor cavity mixes with the oil that is exiting through the heat sinks in the inverter prior to entering into the coolant passages in the stator.

In some forms, the housing includes a bearing support that is disposed concentrically about the rotor, and a rotor bearing is mounted on the bearing support and the bearing support to support the rotor for rotation about the first axis relative to the housing. Optionally, the inverter includes a circuit board assembly that is electrically coupled to the MOSFET's, and the circuit board assembly has an annular configuration that is mounted about a portion of the bearing support on which the rotor bearing is mounted. Optionally, an electric insulator is disposed between the circuit board assembly and the bearing support.

Further areas of applicability will become apparent from the description provided herein. The description and specific examples in this summary are intended for purposes of illustration only and are not intended to limit the scope of the present disclosure.

### DRAWINGS

The drawings described herein are for illustrative purposes only of selected embodiments and not all possible implementations, and are not intended to limit the scope of the present disclosure.
Figures 1 and 2 are longitudinal section views of an exemplary electric drive module constructed in accordance with the teachings of the present disclosure;
Figures 3 and 4 are sections view of a portion of the electric drive unit of Figure 1, illustrating the construction of a motor assembly in more detail;
Figures 5 and 6 are partly sectioned views of the electric drive unit of Figure 1;
Figures 7 and 9 are perspective views of a portion of the motor assembly, illustrating a portion of an inverter in more detail;
Figures 8 and 10 are similar to Figures 7 and 9, respectively, but depict a portion of the inverter in a see-through manner so that a plurality of MOSFET's are more easily seen;
Figure 11 is a perspective view of a portion of the inverter, illustrating a MOSFET as connected to a heat sink;
Figure 12 is a rear perspective view illustrating a MOSFET as connected to a heat sink;
Figure 13 is a rear perspective view of a heat sink;
Figure 14 is an exploded perspective view of a MOSFET, a solder material and a heat sink;
Figure 15 is a perspective view of the inverter shown with an end plate;
Figure 16 is a sectional view of a portion of the electric drive unit of Figure 1, illustrating a sensor assembly having a TMR sensor that is mounted to a control board and a magnet that is coupled for rotation with a rotor of the motor assembly;
Figure 17 is a perspective view of the electric drive unit of Figure 1;
Figure 18 is a rear perspective view of a portion of a housing of the electric drive unit of Figure 1;
Figure 19 is a perspective view of a portion of the electric drive unit of Figure 1 with the portion of the housing shown in Figure 18 removed;
Figure 20 is similar to that of Figure 19, but depicting the electric drive unit with a portion of a transmission and a differential assembly removed;
Figure 21 is similar to that of Figure 20, but depicting a further portion of the housing removed to better show a portion of the transmission;
Figure 22 is a sectional view of a portion of the electric drive unit that is shown in Figure 21;
Figures 23 through 44 are section views of various portions of the electric drive unit of Figure 1, depicting the flow of cooling and lubricating oil through various portions of the electric drive unit;
Figure 45 through 60 are various views of an alternately configured inverter;
Figure 61 is a perspective view depicting the mounting of a cover to the inverter of Figure 45 and the assembly of the inverter to a housing of an alternately configured electric drive unit;
Figure 62 is similar to the view of Figure 61 with the cover removed from the inverter;
Figure 63 is similar to the view of Figure 62 with a bearing support removed;
Figure 64 is similar to the view of Figure 63 with the inverter removed to show the stator;
Figure 65 is a section view through the alternately configured electric drive unit depicting the flow of cooling oil through a field capacitor and to the stator;
Figure 66 is an enlarged portion of Figure 65;
Figure 67 is a section view of a portion of the alternately configured electric drive unit depicting where cooling oil leaves a cavity that holds a field capacitor and merges with a flow of cooling oil that passes through the heat sinks prior to the merged flow entering coolant passages formed in the stator;
Figure 68 is a front perspective view of the field capacitor;
Figure 69 is a rear perspective view of a portion of the field capacitor;
Figure 70 is a perspective view of a portion of the housing of the alternately configured electric drive unit showing a field capacitor cavity for holding the field capacitor;
Figure 71 is a perspective view of a portion of the alternately configured electric drive unit illustrating the mounting of the field capacitor to the housing via a plurality of screws; and
Figure 72 is a section view of a portion of the alternately configured electric drive unit taken through the bearing support and illustrating an insulator axially between the circuit board assembly and a flange formed on the bearing support.

Corresponding reference numerals indicate corresponding parts throughout the several views of the drawings.

### DETAILED DESCRIPTION

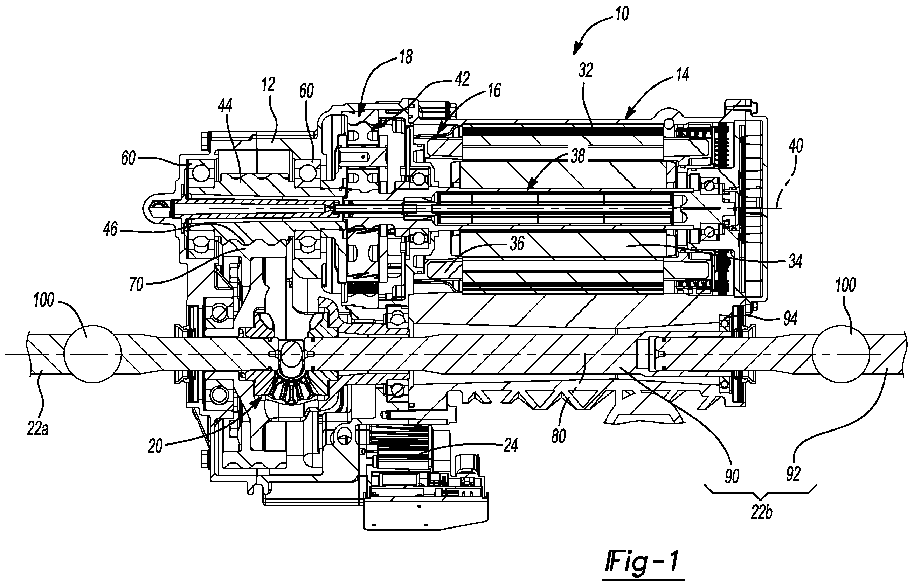

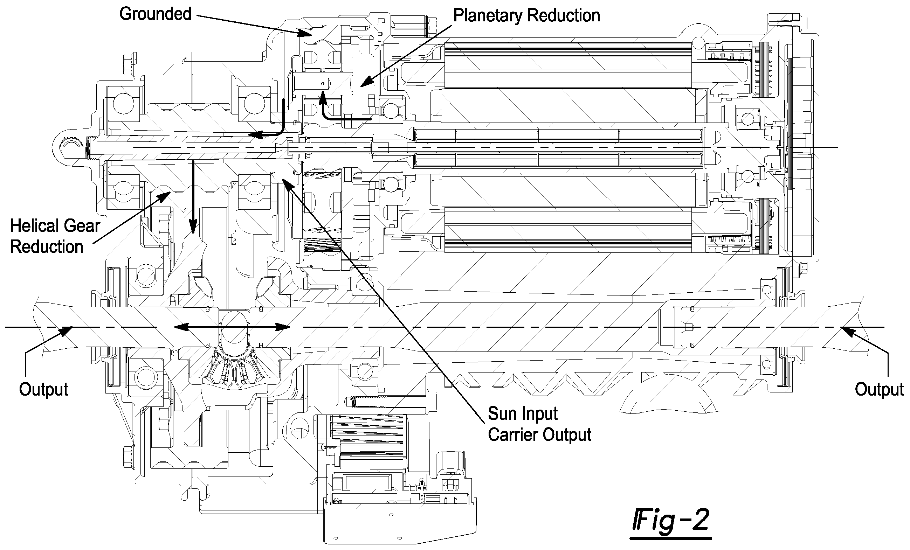

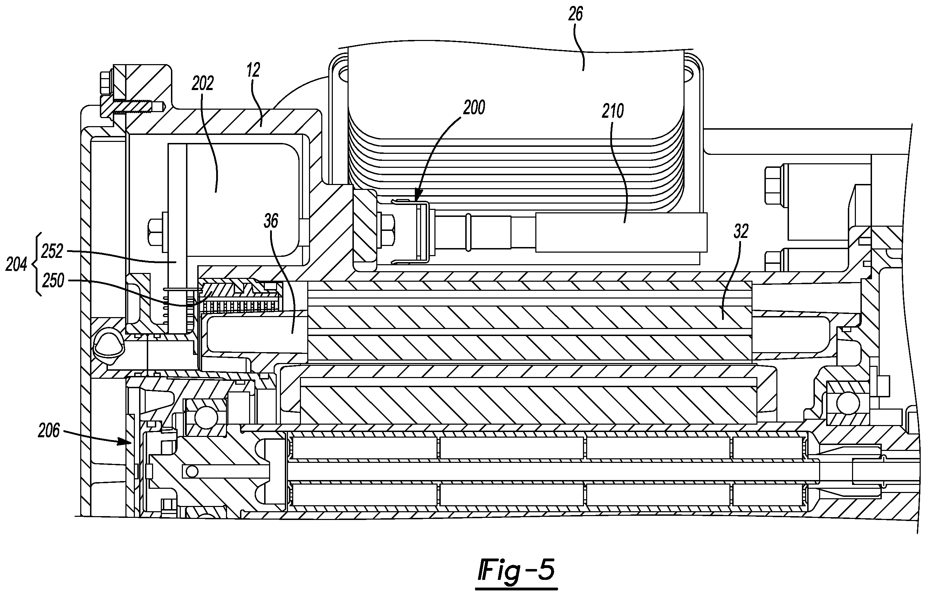

With reference to Figures 1 and 2, an exemplary electric drive module constructed in accordance with the teachings of the present disclosure is generally indicated by reference numeral 10. The electric drive module 10 includes a housing assembly 12, an electric motor 14, a control unit 16, a transmission 18, a differential assembly 20, a pair of output shafts 22a and 22b, a pump 24, a heat exchanger 26 (Fig. 5) and a filter 28.

The housing assembly 12 can house the motor 14, the control unit 16, the transmission and the differential assembly 20. The electric motor 14 can be any type of electric motor and can have a stator 32 and a rotor 34. The stator 32 can include field windings 36, whereas the rotor 34 can include a rotor shaft 38 that can be disposed within the stator 32 for rotation about a first rotational axis 40.

The transmission 18 can include a planetary reduction 42, a shaft 44 and a transmission output gear 46. The planetary reduction can have a sun gear, which can be unitarily and integrally formed with the rotor shaft 38 to keep pitch line velocity as low as possible, a ring gear, which can be grounded to or non-rotatably coupled to the housing assembly 12, a planet carrier and a plurality of planet gears that can be journally supported by the planet carrier and which can be meshingly engaged with both the sun gear and the ring gear. The sun gear, the ring gear and the planet gears can be helical gears. The shaft 44 can be mounted to a set of bearings 60 that support the shaft for rotation about the first rotational axis 40 relative to the housing assembly 12. The transmission output gear 46 can be coupled to (e.g., unitarily and integrally formed with) the shaft 44 for rotation therewith about the first rotational axis 40.

The differential assembly 20 can include a final drive or differential input gear 70 and a differential. The differential input gear 70 can be rotatable about a second rotational axis 80 and can be meshingly engaged to the transmission output gear 46. In the example provided, the transmission output gear 46 and the differential input gear 70 are helical gears. The differential can be any type of differential mechanism that can provide rotary power to the output shafts 22a and 22b while permitting (at least in one mode of operation) speed differentiation between the output shafts 22a and 22b. In the example provided, the differential includes a differential case, which is coupled to the differential input gear 70 for rotation therewith, and a differential gearset having a plurality of differential pinions, which are coupled to the differential case and rotatable (relative to the differential case) about one or more pinion axes that are perpendicular to the second rotational axis 80, and a pair of side gears that are meshingly engaged with the differential pinions and rotatable about the second rotational axis 80. Each of the output shafts 22a and 22b can be coupled to an associated one of the side gears for rotation therewith. In the example provided, the output shaft 22b is formed as two distinct components: a stub shaft 90 and a half shaft 92. The stub shaft 90 is drivingly coupled to an associated one of the side gears and extends between an associated gear and the half shaft 92 and is supported by a bearing 94 in the housing assembly 12 for rotation about the second rotational axis 80. Each of the output shaft 22a and the half shaft 92 has a constant velocity joint 100 with a splined male stem. The splined male stem of the constant velocity joint on the output shaft 22a is received into and non-rotatably coupled to an associated one of the side gears. The splined male stem of the constant velocity joint on the half-shaft 92 is received into and non-rotatably coupled to the stub shaft 90.

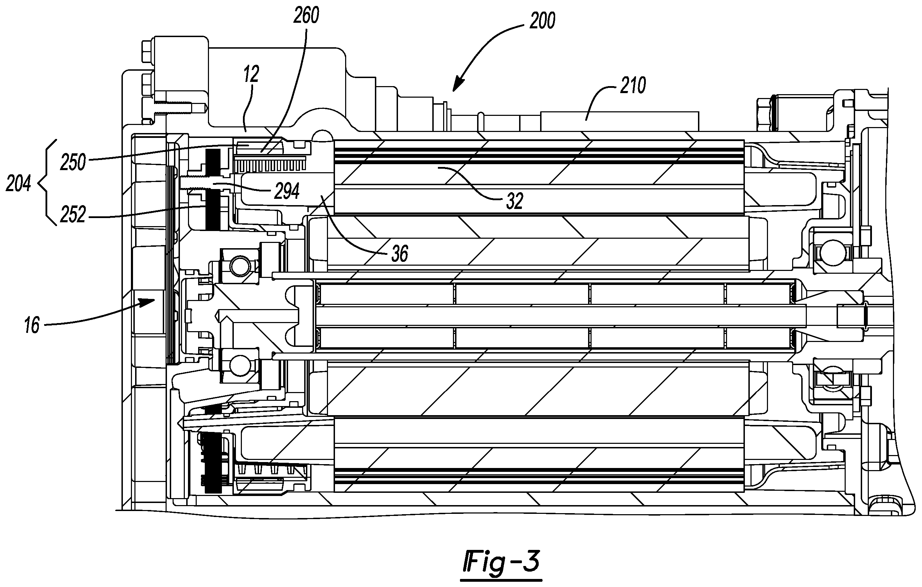

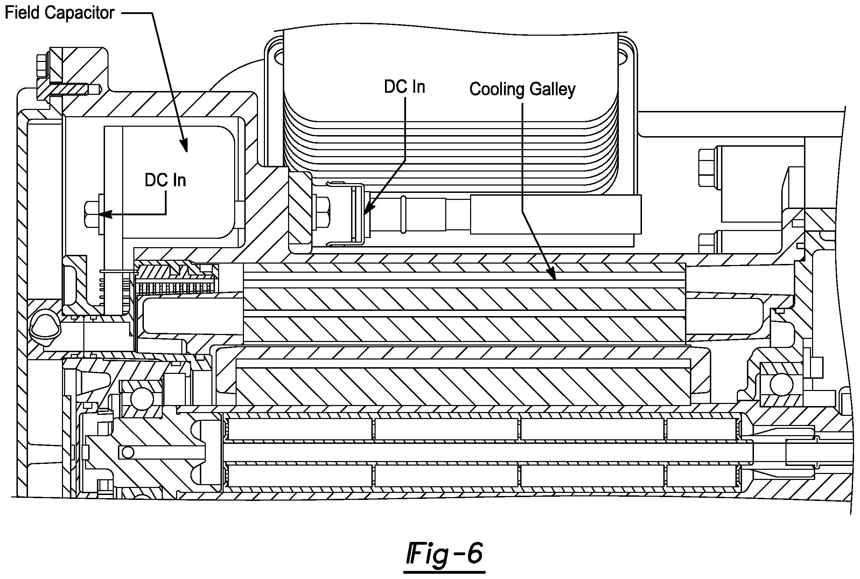

In Figures 3 through 6, the control unit 16 includes a power terminal 200, one or more field capacitor 202, an inverter 204 and a controller 206. The power terminal 200 can be mounted to the housing assembly 12 and can have contacts or terminals (not shown) that can be fixedly coupled to a respective power lead 210 to electrically couple the power lead 210 to the control unit 16. It will be appreciated that the electric motor 14 can be powered by multi-phase electric AC power and as such, the power terminal 200 can have multiple contacts or terminals to permit the several power leads 210 to be coupled to the control unit 16.

Each field capacitor 202 electrically couples an associated one of the power leads 210 to the inverter 204. In the example provided, each field capacitor 202 is relatively small and is disposed in an annular space between the inverter 204 and the housing assembly 12. The annular space can be disposed adjacent to an end of a body of the stator 32 from which the field windings 36 extend. Each field capacitor 202 can be mounted to the inverter 204.

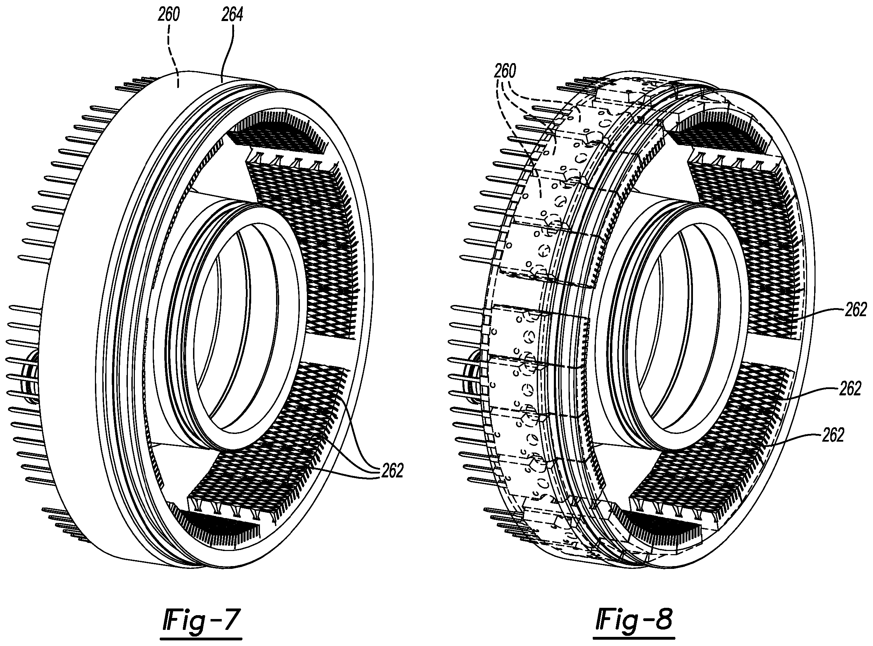

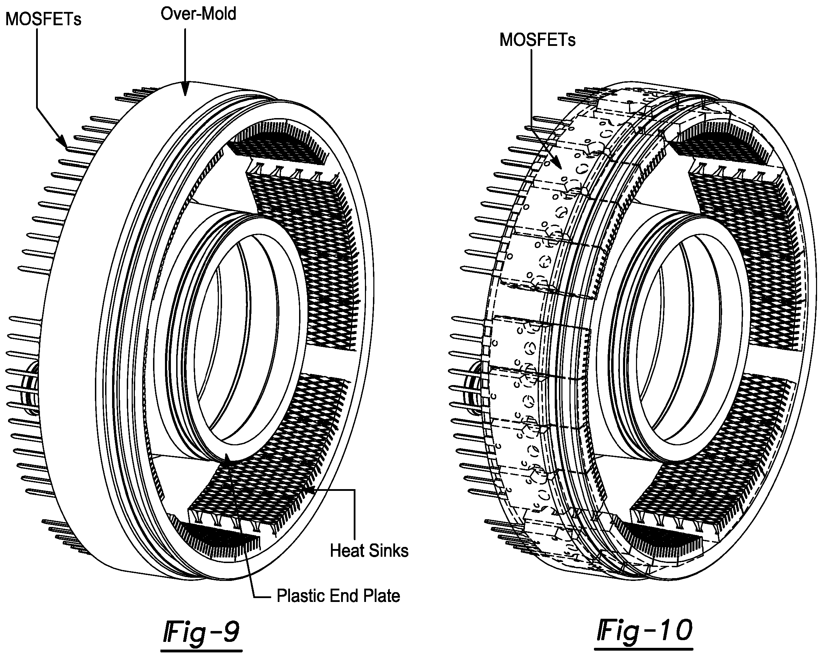

With reference to Figures 3, 4 and 7 through 10, the inverter 204 can be an annular structure that can be mounted about the field windings 36 that extend from the body of the stator 32. In the example provided the inverter 204 includes a transistor assembly 250 and a circuit board assembly 252. The transistor assembly 250 can comprise a plurality of surface mount MOSFET's 260, a plurality of heat sinks 262, and a retaining member 264.

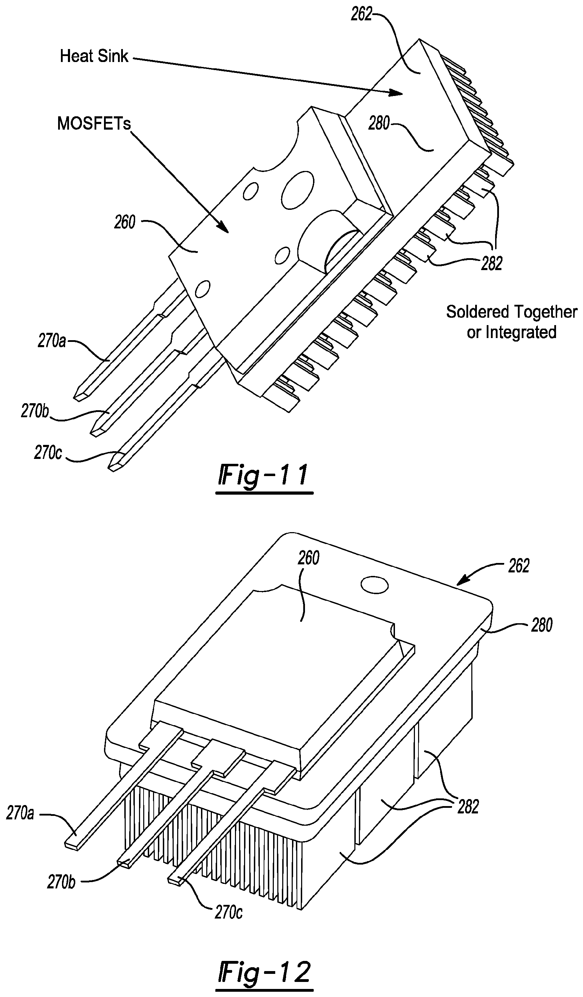

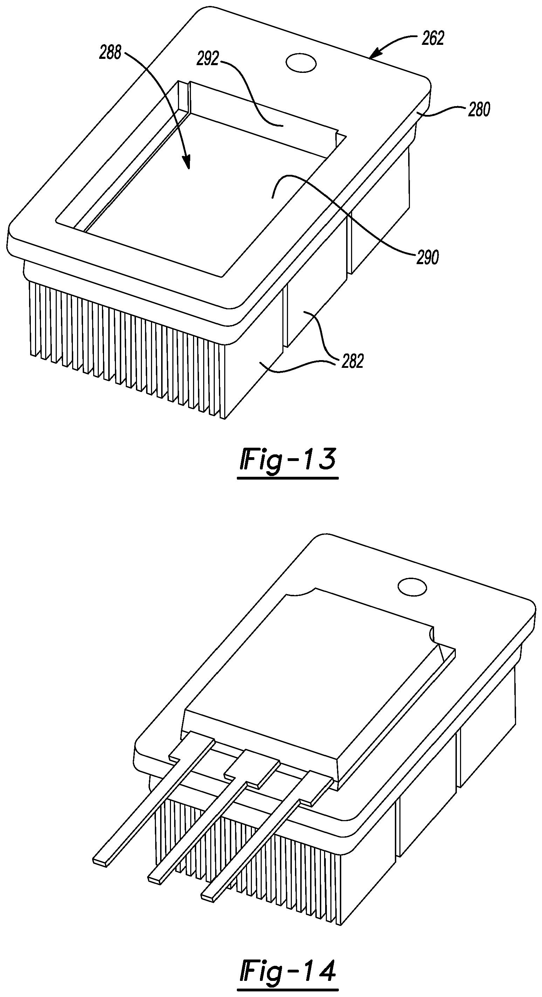

With reference to Figures 11 through 14, each of the MOSFET's 260 can include a plurality of pin terminals 270a, 270b and 270c and a surface-mount power terminal (not specifically shown). The surface-mount power terminal of each MOSFET 260 can be soldered to an associated one of the heat sinks 262. In the example provided, each heat sink 262 has a base 280 and a plurality of fins 282 that extend from the base 280. The base 280 can optionally define a pocket 288 that is configured to receive the MOSFET 260. The pocket 288 has a bottom surface 290. A riser 292, which is a tapered surface of the pocket that provides clearance between the heat sink 262 and the MOSFET 260, can be provided to permit air to vent from/prevent air entrapment in the pocket 288 when the MOSFET 260 is received into the pocket 288 and soldered to the bottom surface 290. The solder can be placed into the pocket 290 prior to inserting the MOSFET 260 into the pocket 288. The solder can optionally be in the form of a metal foil. The retaining member 264 can be a suitable electrically insulating plastic material that can be overmolded onto the MOSFET's 260 and heat sinks 262.

The plastic of the retaining member 264 can cohesively bond to the MOSFET's 260 and the heat sinks 262 to thereby fixedly couple the MOSFET's and heat sinks 262 to one another. Configuration in this manner eliminates relative motion between the MOSFET's 260 and between each of the MOSFET's 260 and its associated heat sink 262, as well as creates a fluid-tight seal that inhibits fluid migration from the interior of the transistor assembly 250 in a radially outward direction. The retaining member 264 can carry a seal that can form a seal between the retaining member 264 and the housing 12.

If desired, the solder can be a relatively low temperature solder that has a melting point that is below a predetermined target temperature. The target temperature can be a temperature that is below a maximum operating temperature of the transistor assembly 250. For example, the target temperature can be the expected temperature of the transistor assembly 250 when the electric motor 14 (Fig. 1) was powered at approximately 30%, 50%, or 80% of maximum power for a predetermined time interval, such as three hours. In such situation, the solder between the surface-mount power terminal and the heat sink 262 would be expected to melt from time to time during the operation of the electric drive module 10 (Fig. 1). The melted solder would remain conductive and the retaining member 264 would both inhibit relative movement between the MOSFET's 260 and the heat sinks 262 but also inhibit migration of the liquid solder out of the pocket 288 and away from the interface between the surface-mount power terminal and the bottom surface 290 of the pocket 288. As such, the melting of the solder would not impair operation of the electric motor 14 (Fig. 1). Furthermore, the solder would eventually cool and re-bond the surface-mount power terminal to the bottom surface 290 of the pocket 288. It will be appreciated that different alloys could be employed to tune the melt point of the solder to a desired temperature or temperature range.

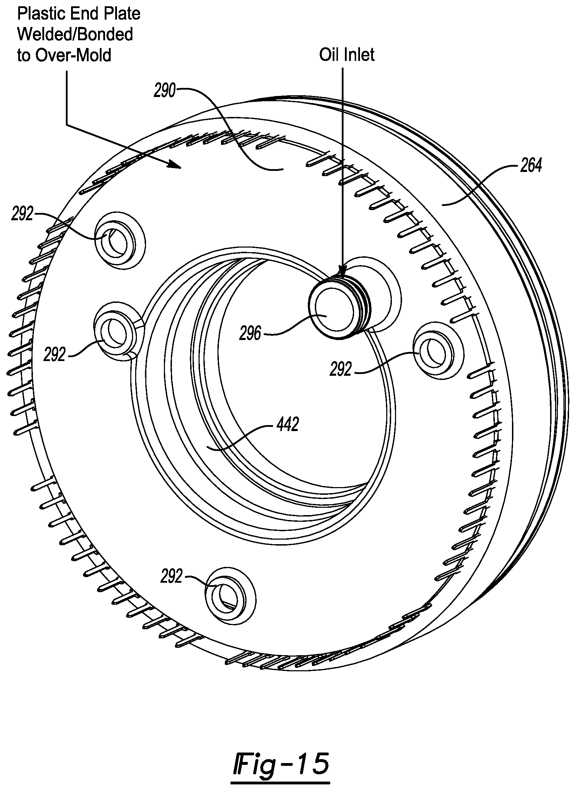

With reference to Figure 15, an annular end plate 290 can be fixedly and sealingly coupled to the retaining member 264. The end plate 290 can include a plurality of phase lead bosses 292, which can accept phase leads 294 (Fig. 3) of the field windings 36 (Fig. 3) therethrough, as well as an oil inlet port 296.

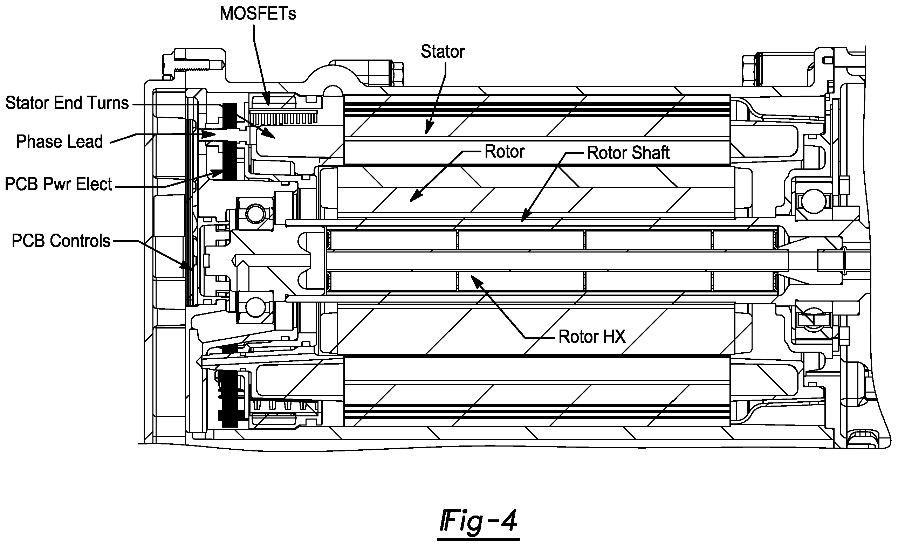

In Figures 3 and 4, the circuit board assembly 252 can comprise a plurality of printed circuit boards that can be stacked against one another and electrically coupled to the pin terminals of the MOSFET's 260 as well as to the phase leads 294 of the field windings 36 of the stator 32. The quantity of printed circuit boards is dependent upon the thickness of the electrical traces or conductors on each of the printed circuit boards and the amount of current that is to pass through between each MOSFET 260 and an associated one of the field windings 36.

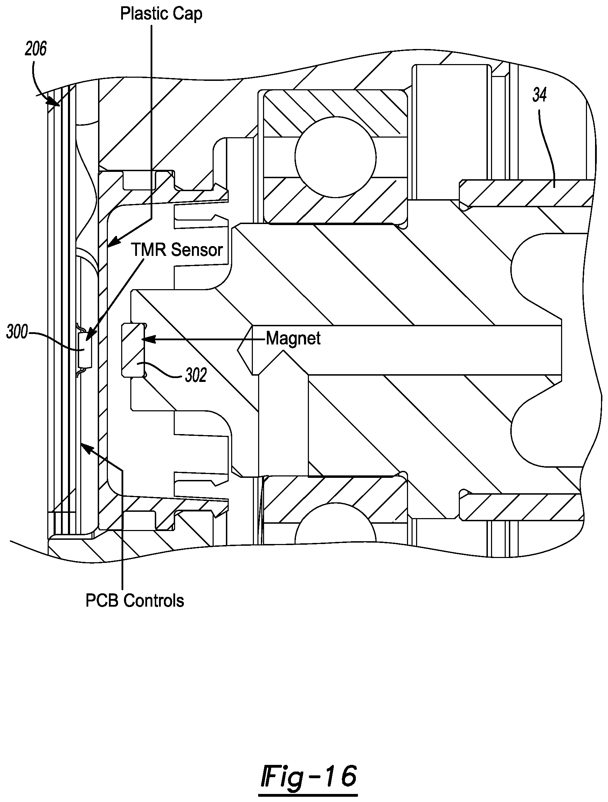

With reference to Figure 16, the controller 206 is configured to sense a rotational position of the rotor 34 relative to the stator 32 (Fig. 1) and responsively control the flow of electric power from the inverter 204 (Fig. 3) to the field windings 36 (Fig. 3) to rotate the magnetic field that is produced by the field windings 36 (Fig. 3). The controller 206 can include a second circuit board assembly that can comprise a plurality of stacked printed circuit boards. The second circuit board assembly can have conventional hardware and control programming for operating the electric motor 14 (Fig. 1) and a TMR sensor 300 that is configured to sense a rotational position of a magnetic field of a magnet 302 that is fixedly coupled to the rotor 34. The TMR sensor 300 and the magnet 302 can optionally be used in place of a conventional encoder or resolver. Significantly, the controller 206 uses direct voltage traces on the various printed circuit boards and/or the pins of the MOSFETS instead of resistors to determine current flow.

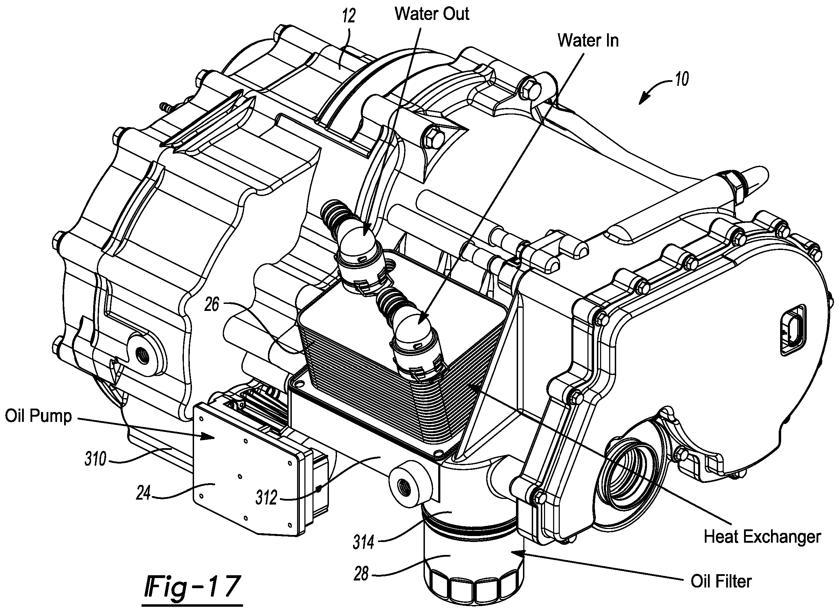

In Figure 17, the housing assembly 12 is shown to have a pump mount 310, a heat exchanger mount 312 and a filter mount 314. The pump 24 can be mounted to the pump mount 310 and can circulate an appropriate fluid about the electric drive module 10 to both lubricate and/or cool various components. In the example provided the fluid is a suitable dielectric fluid, such as automatic transmission fluid. The heat exchanger 26 can be mounted to the heat exchanger base 312 and can be configured to receive a pressurized cooling fluid, such as a water-glycol mixture, from an external source and to facilitate the transfer of heat from the dielectric fluid circulated in the electric drive module 10 to the pressurized cooling fluid. A suitable filer, such as a spin-on oil filter 28, can be mounted to the filter base 314 and can filter the dielectric fluid that is circulated within the electric drive module.

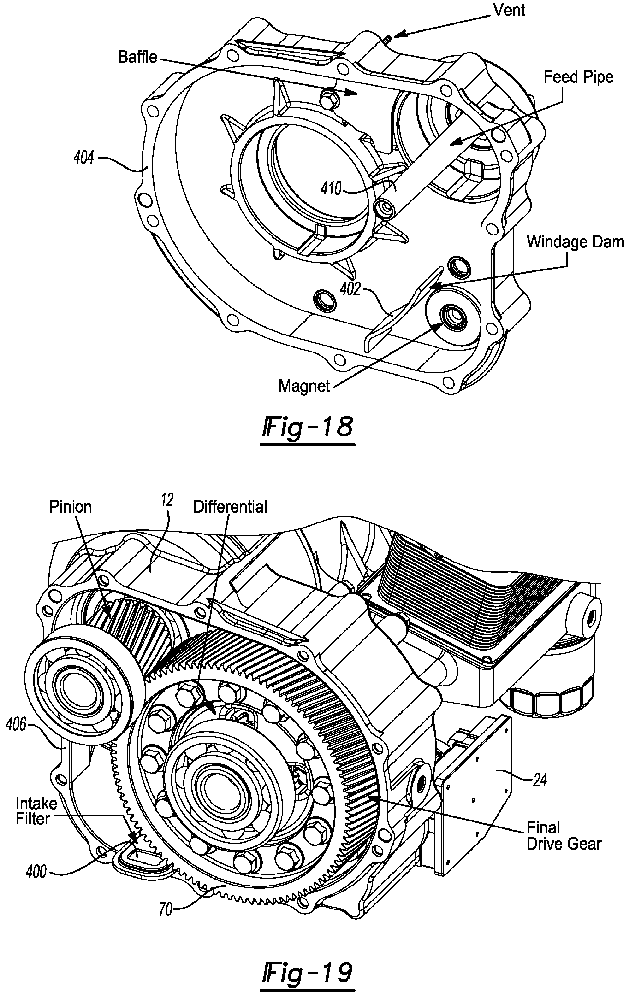

With reference to Figures 18 through 20, an intake filter or screen 400 can be disposed in a portion of the housing assembly 12 that houses the differential input gear 70. The intake filter 400 can receive dielectric fluid that can be returned to the low-pressure side of the pump 24. A windage dam 402 can be integrated into a cover 404 and a main housing portion 406 of the housing assembly 12 to shield the dielectric fluid that is being returned to the intake filter 400 from the differential input gear 70. More specifically, the windage dam 402 can cause dielectric fluid to accumulate in the vicinity of the intake filter 400 and segregate the accumulated fluid from the (rotating) differential input gear 70. It will be appreciated that without the windage dam 402, the rotating differential input gear 70 would tend to pull dielectric fluid away from the intake filter 2400, which could prevent sufficient dielectric fluid from being returned to the low pressure (intake) side of the pump 24. It will also be appreciated that segregating the dielectric fluid from the rotating differential input gear 70 can reduce drag losses that would otherwise be incurred from the rotation of the differential input gear 402 through the dielectric fluid. The cover 404 can also include a tubular feed pipe 410.

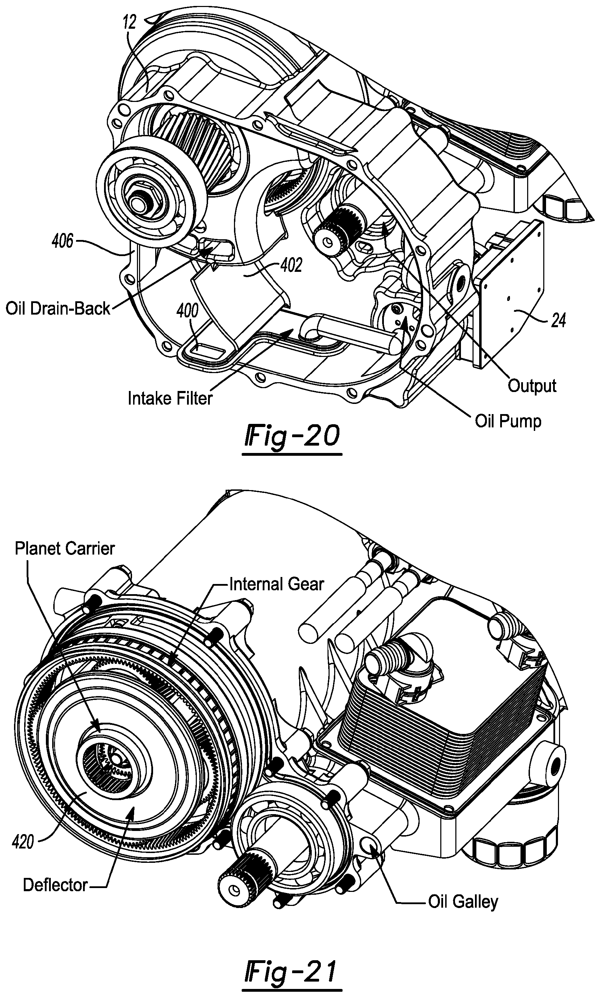

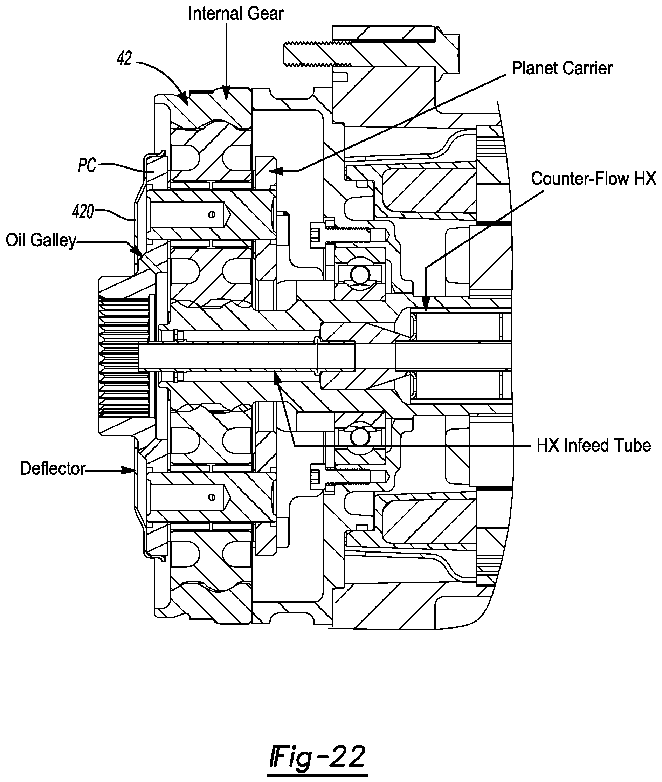

With reference to Figures 21 and 22, a deflector 420 can be mounted to the planet carrier PC and can shield the planetary reduction 42 from dielectric fluid that is slung from other rotating components and/or cause dielectric fluid to drain from the planetry reduction 42 in a desired manner.

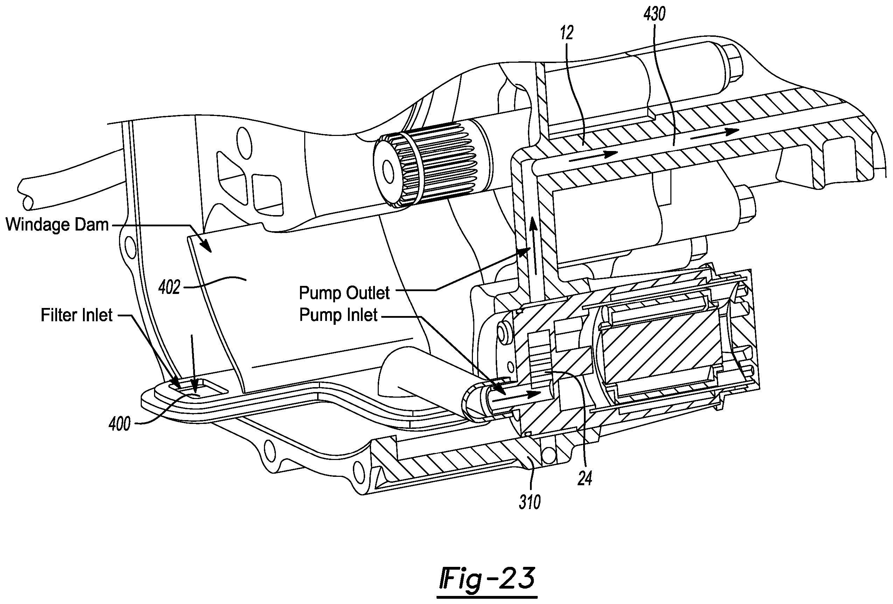

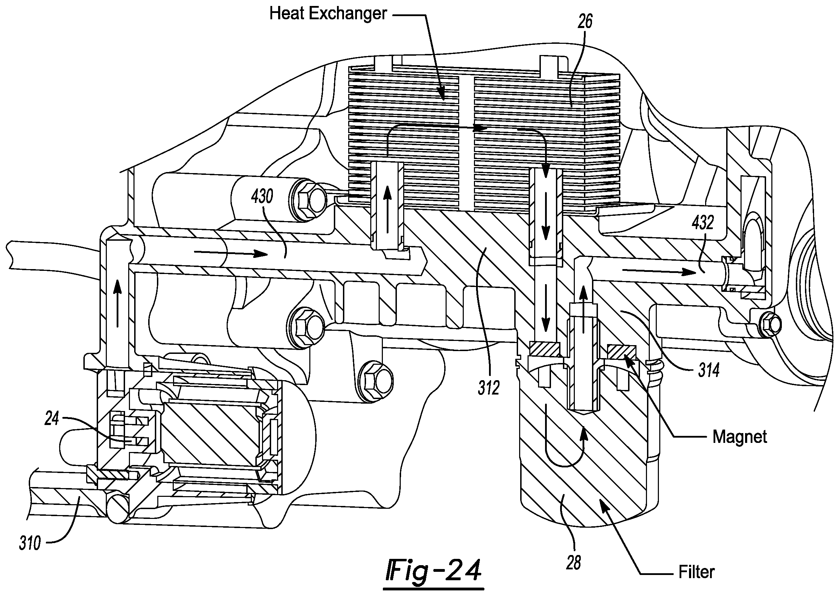

In Figures 23 and 24, dielectric fluid is received into the intake filter 400 and transmitting to the low pressure (inlet) side of the pump 24. High pressure dielectric fluid exits the pump 24 and travels through an internal gallery 430 in the housing 12 to an inlet passage of the heat exchanger base 312, through the heat exchanger 26, into an outlet passage of the heat exchanger base 312, into an inlet passage of the filter base 314, through the filer 28, into an outlet passage in the filter base 314 and to another internal gallery 432 in the housing 12.

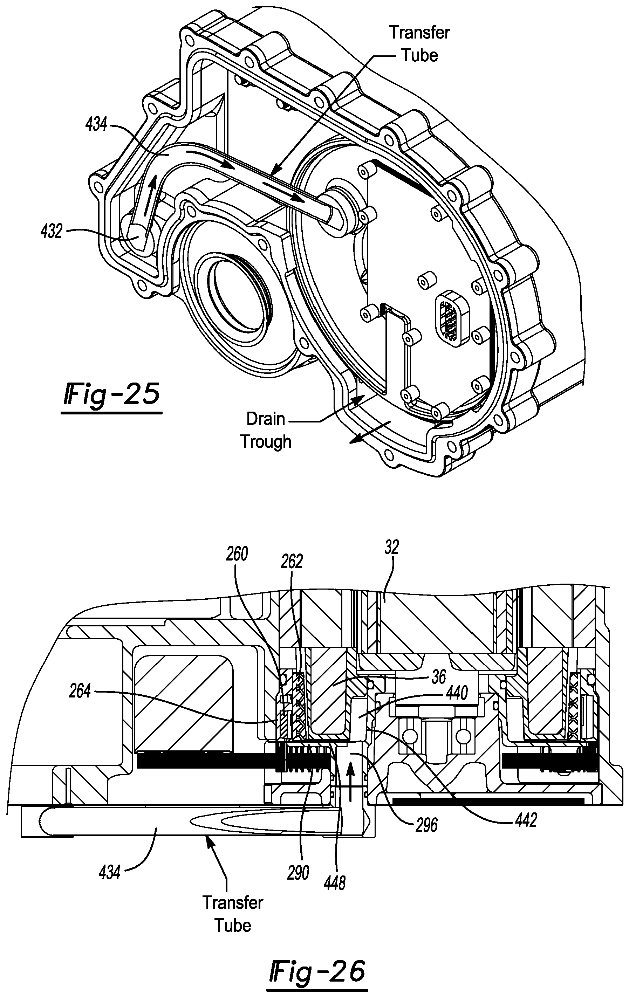

In Figures 25 and 26, dielectric fluid exiting the internal gallery 432 can travel through a transfer tube 434 through the oil inlet port 296 in the end plate 290 and can enter an annular cavity 440 that is located radially between a tubular central projection 442 on the end plate 290 and the field windings 36. The central projection 442 can carry a seal that can be sealingly engaged to the central projection 442 and to the field windings 36. An annular gap 448 is formed between an axial end of the field windings 36 and an annular portion of the end plate 290. As noted previously, the end plate 290 is fixedly and sealingly coupled to the retaining member 264 of the transistor assembly 250.

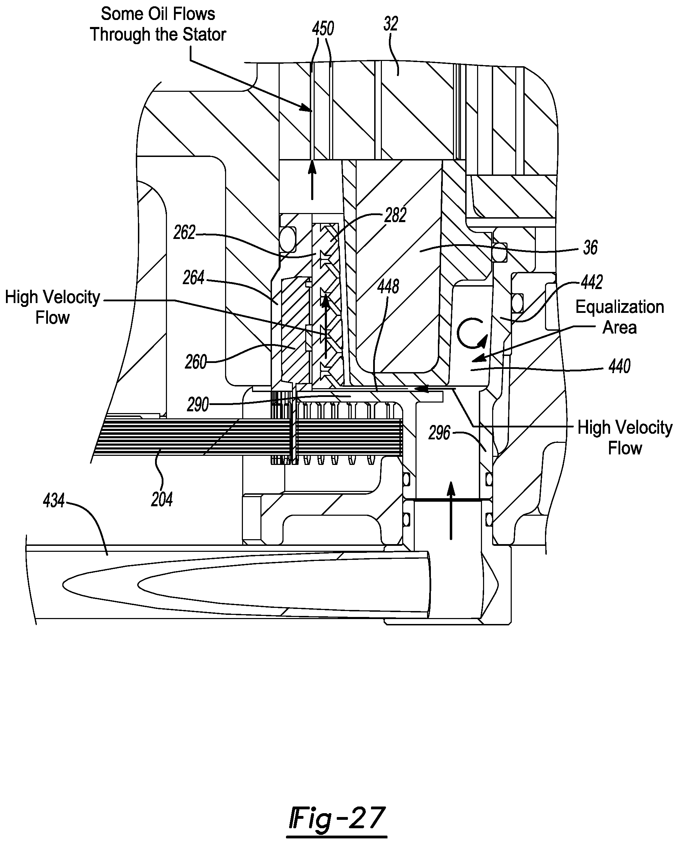

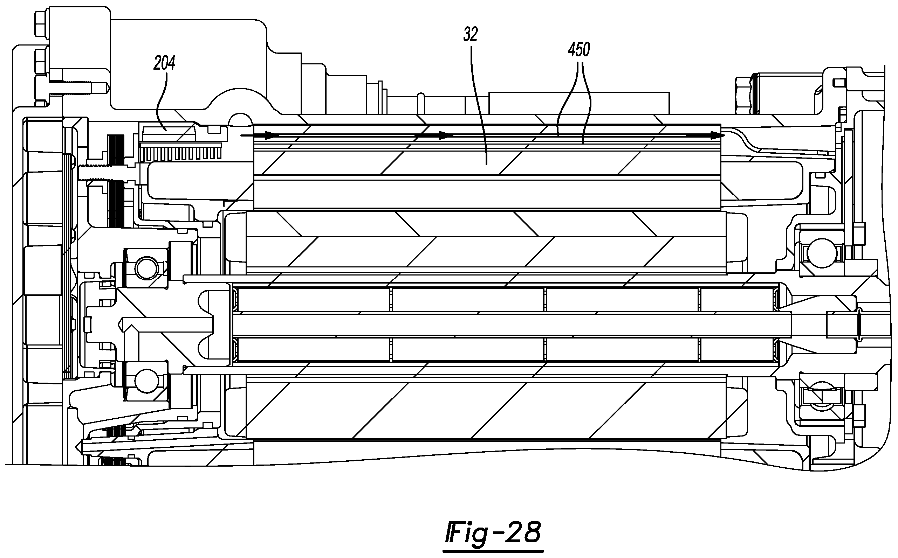

In Figure 27, the dielectric fluid is shown to flow through the annular gap 448, through the fins 282 in the heat sinks 262 and into passages 450 formed axially through the stator 32. While the fins 282 have been depicted herein as perpendicular projections, it will be appreciated that the fins 282 could be shaped differently (for example, as diamond shaped projections) to cause the flow of dielectric fluid passing through the fins 282 to move in both tangential and axial directions. Flow in this manner may be beneficial for rejecting more heat from the heat sinks 262 into the dielectric fluid and/or to produce a desired flow restriction that can aid in the pressure balancing of the cooling flow to the rotor. Accordingly, it will be appreciated that dielectric fluid is introduced to the inverter 204, passes through fins 282 on heat sinks 262 that are electrically conductively coupled to power terminals of the MOSFET's 260 to thereby cool the inverter 204, and thereafter enters the passages 450 in the stator 32 to cool the stator 32 as is shown in Figure 28.

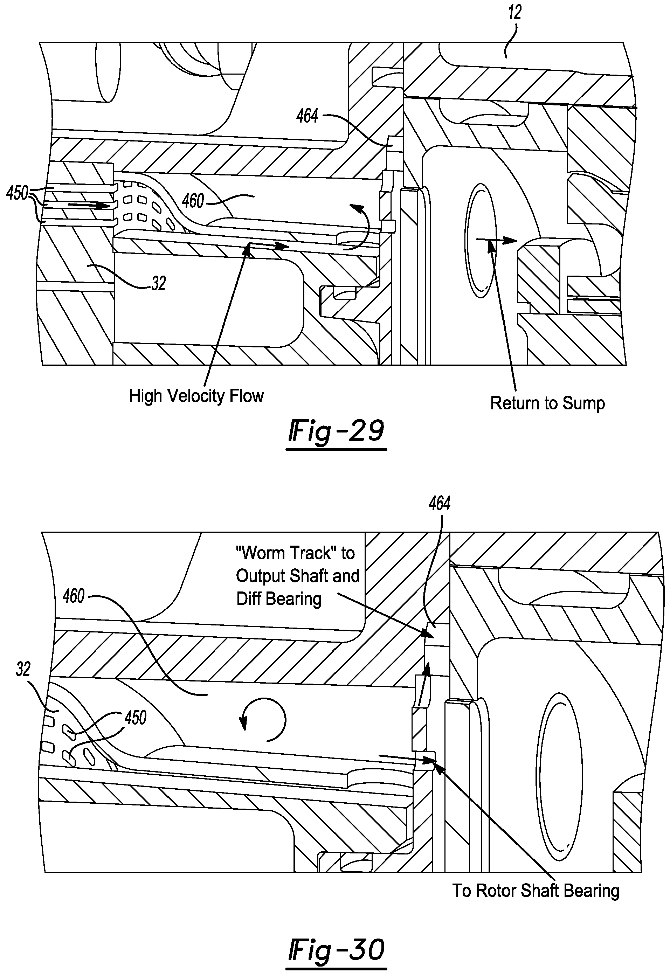

In Figures 29 and 30, dielectric fluid exiting the stator 32 is collected in an annular cavity 460 on an opposite end of the stator 32 that permits the velocity of the dielectric fluid to slow. A portion of the dielectric fluid is returned to a sump (not shown) in the housing assembly 12, while other portions of the flow are directed to lubricate various other components. For example, the annular cavity 460 can be in fluid communication with a worm track 464.

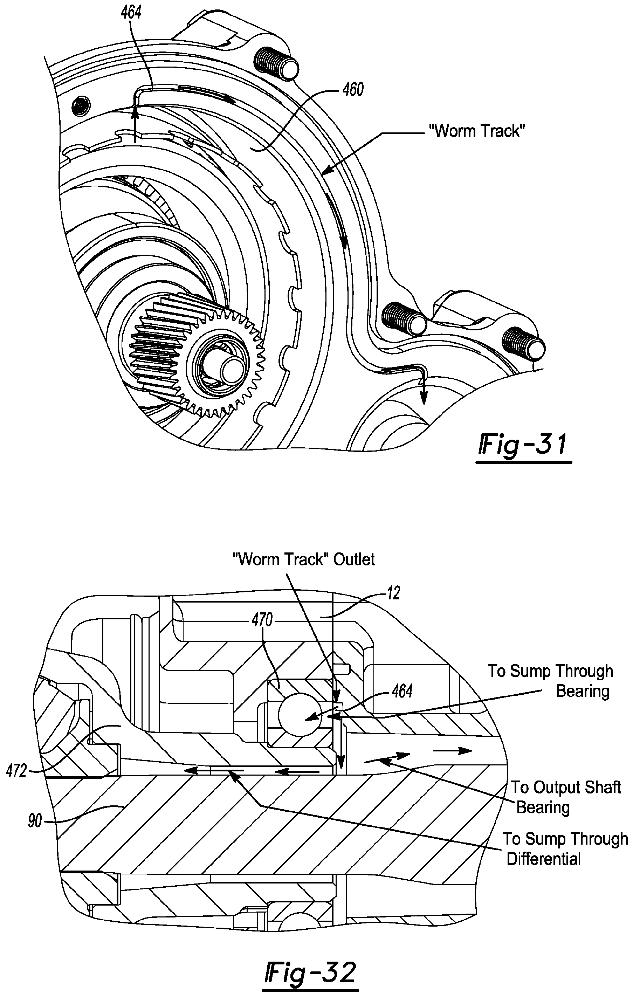

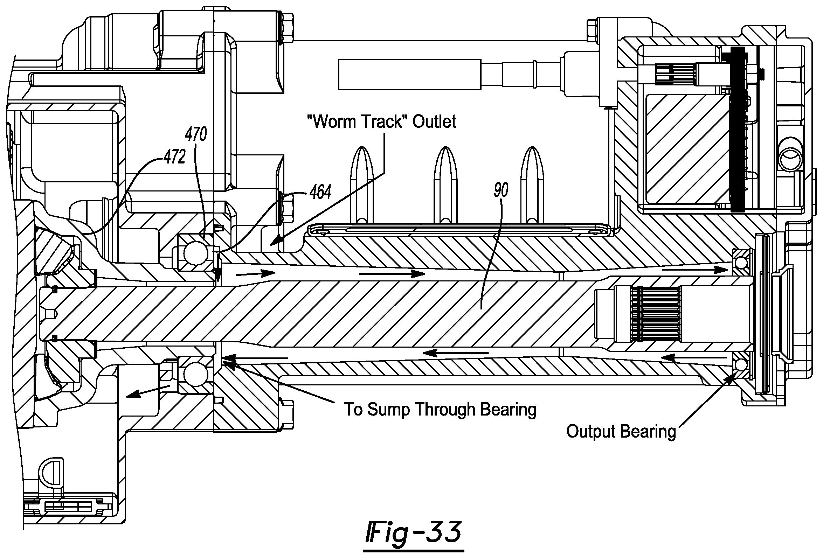

With reference to Figures 31 through 33, the worm track 464 can have an outlet that can discharge the dielectric fluid into a bearing 470, which can support the differential case 472 for rotation relative to the housing assembly 12, and/or onto the stub shaft 92, where the dielectric fluid can migrate to the opposite axial ends of the stub shaft 92 to lubricate the differential gearing and the bearing 94. Thereafter, the dielectric fluid can drain to the sump where it can flow into the intake filter 400 (Fig. 23).

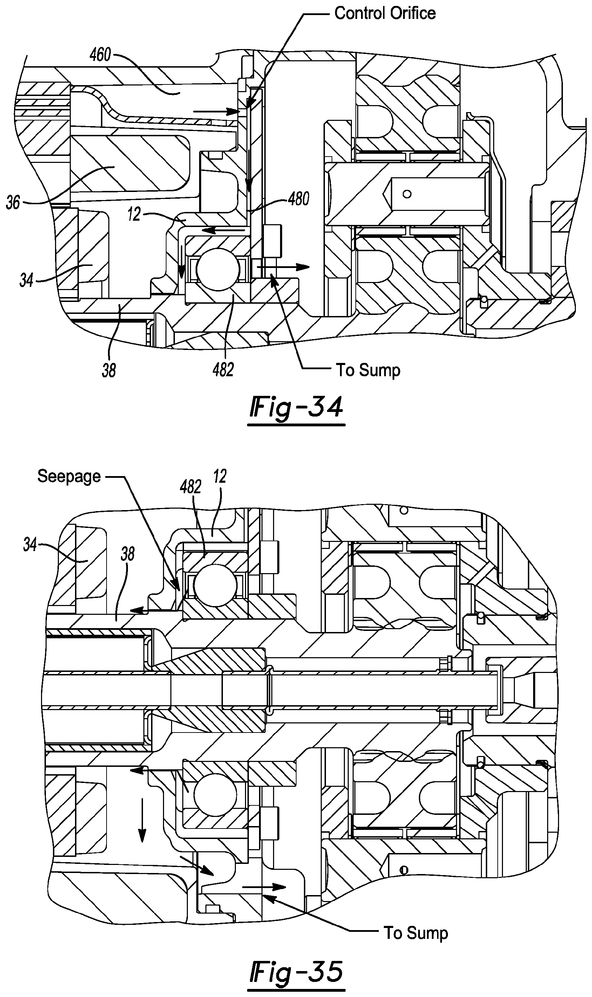

In Figures 34 and 35, the annular cavity 460 can be in fluid communication with a passage 480 that provides a flow of the dielectric fluid to a bearing 482 that supports the rotor shaft 38 relative to the housing assembly 12. Dielectric fluid that is discharged from the gearing 482 can seep between the housing assembly 12 and the rotor shaft 38 and can drain to the sump in the housing assembly 12.

With reference to Figures 26, 27 and 36, a portion of the dielectric fluid in the annular cavity 440 can be discharged into a bypass tube 500. The amount of fluid that is discharged into the bypass tube 500 is based on pressure balancing between the flow that is directed through the bypass tube 500 and the portion of the flow that travels through the inverter 204 and the stator 32.

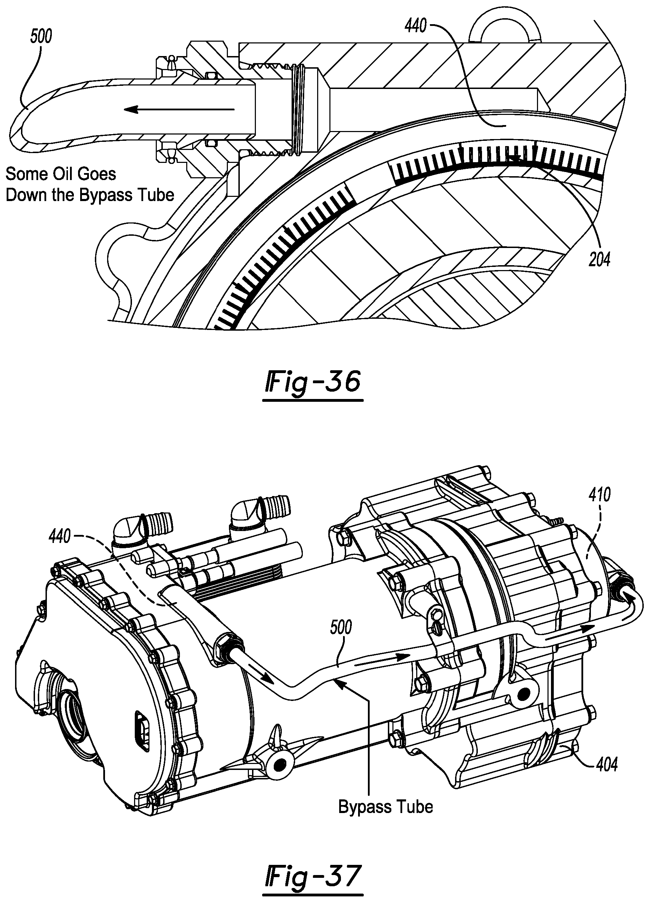

Figure 37 depicts the dielectric fluid as it is discharged from the annular cavity 440 and transferred via the bypass tube 500 to the feed pipe 410 in the cover 404.

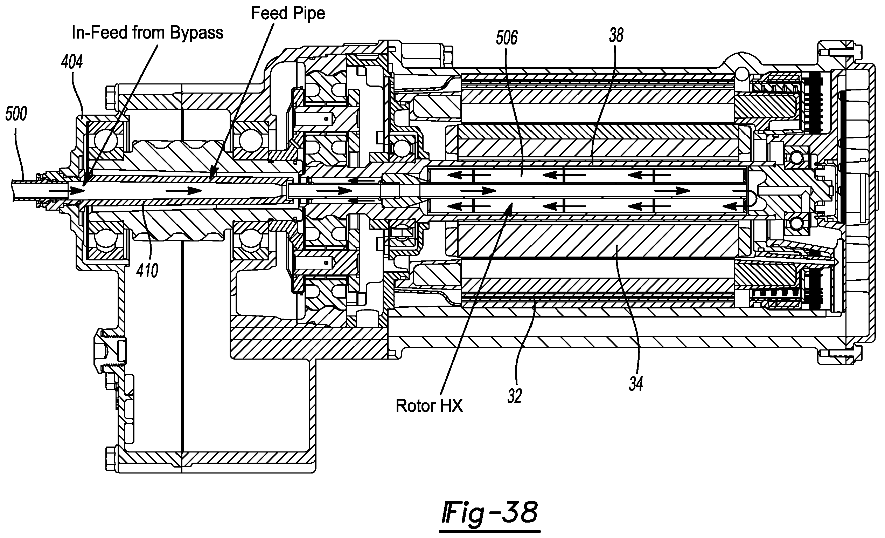

Figure 38 depicts the bypass flow exiting the bypass tube 500, traveling through the feed pipe 410 in the cover 404 and being fed into a heat exchanger 506 that is mounted within the rotor shaft 38. The heat exchanger 506 receives the flow (inflow) of dielectric fluid along its rotational axis, and then turns the flow at the opposite end of the rotor 34 so that the flow of dielectric fluid flows concentrically about the inflow toward the end of the rotor 34 that received the inflow of the dielectric fluid.

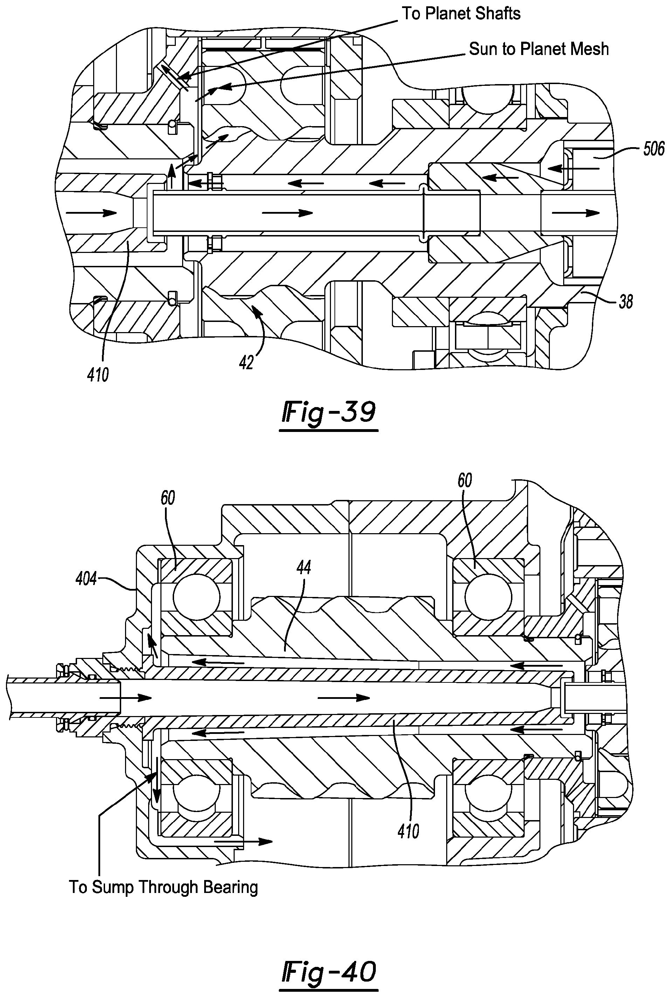

In Figures 39 and 40, the outflow of the dielectric fluid that exits the heat exchanger 506 in the rotor shaft 38 can be at least partly employed to lubricate the various components (i.e., bearings, shafts, gear teeth) of the planetary reduction 42, as well as the bearings 60 that support the shaft 44 of the transmission. Note that the feed pipe 410 in the cover 404 is received through a bore in the shaft 44. In the example provided, the feed pipe 410 is a discrete component that is assembled to the cover 404.

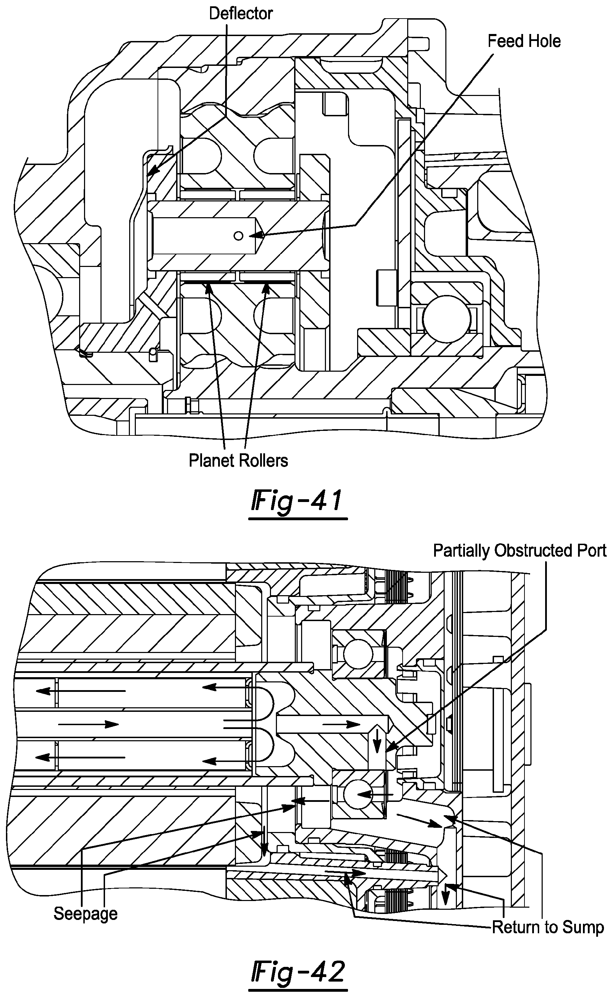

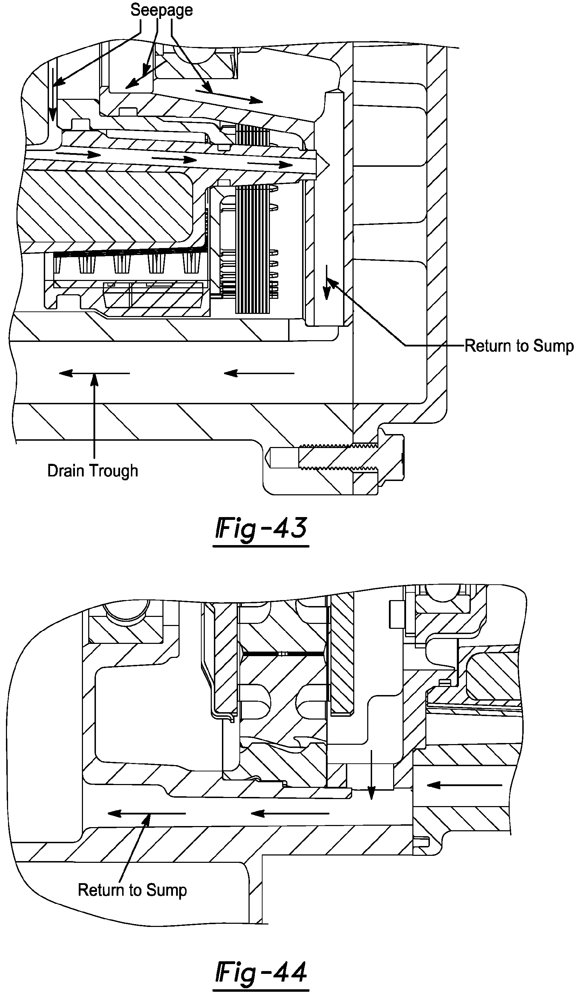

Figures 41 through 44 show various flows of dielectric fluid being used to lubricate various other components within the electric drive module.

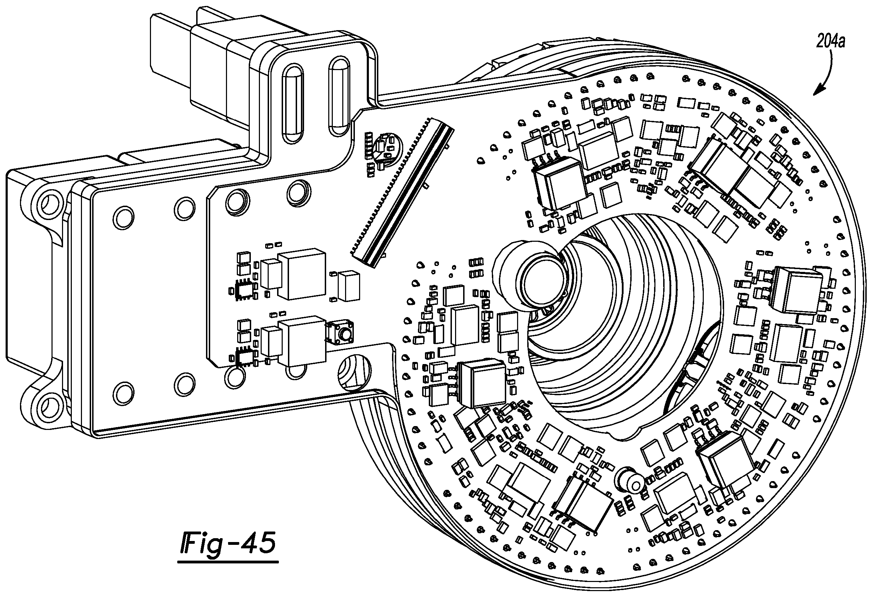

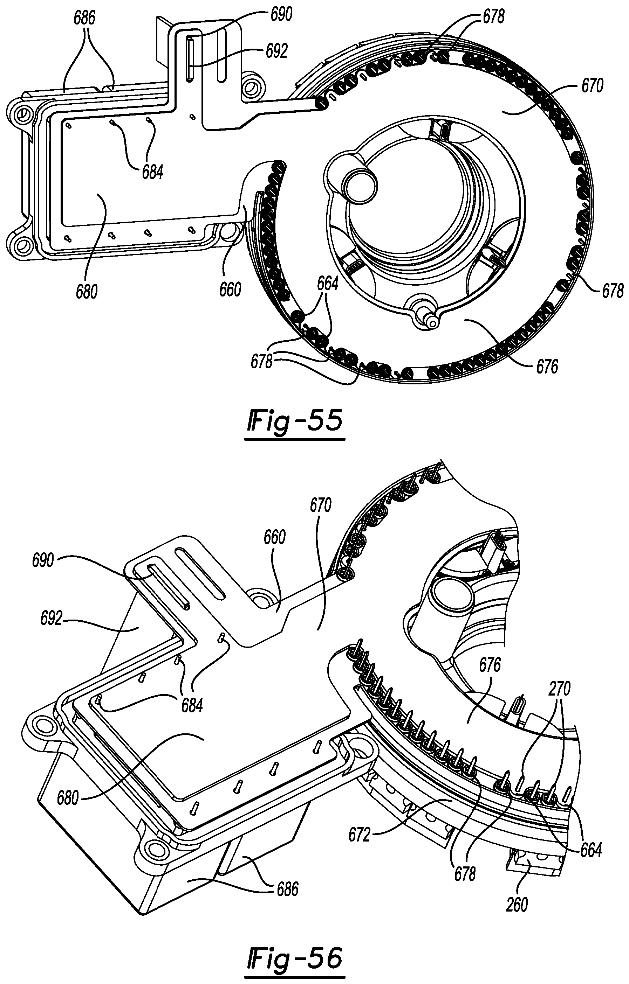

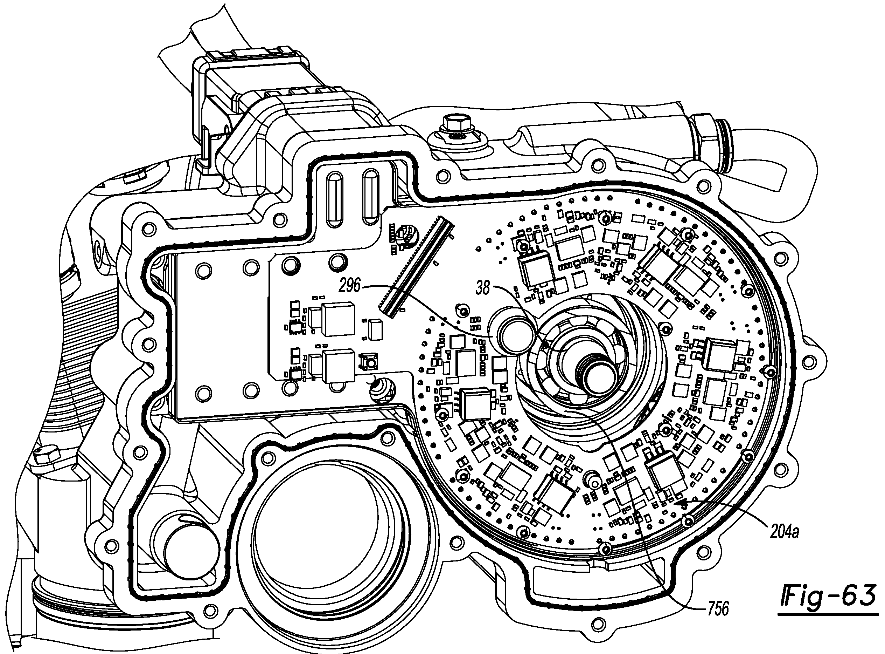

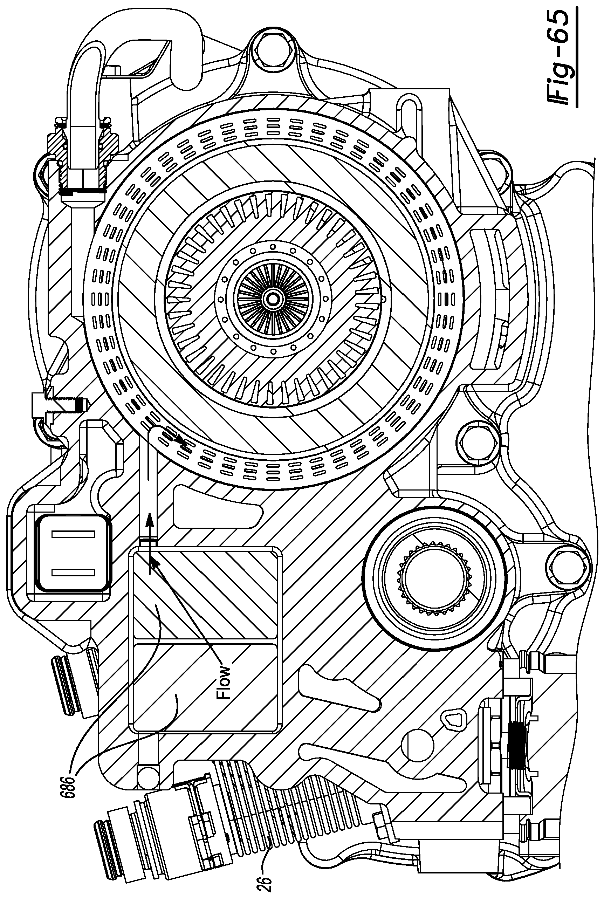

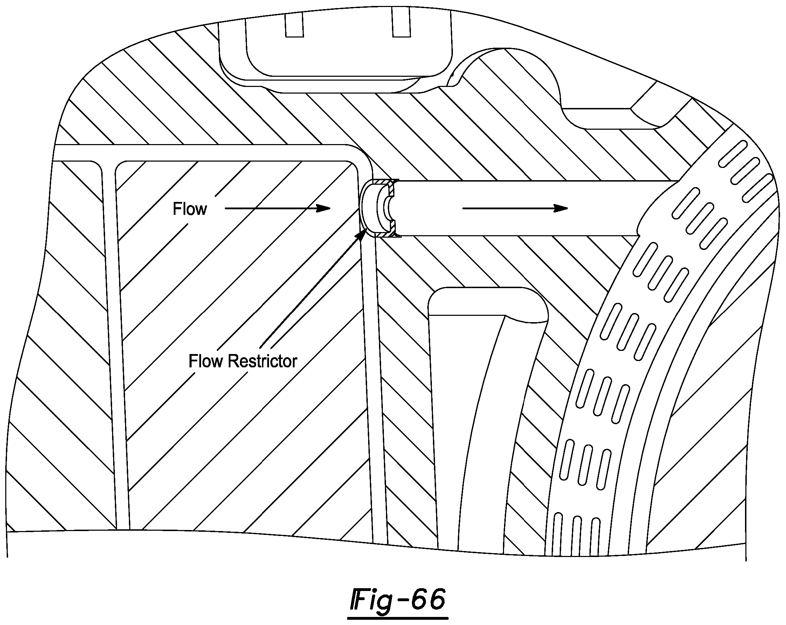

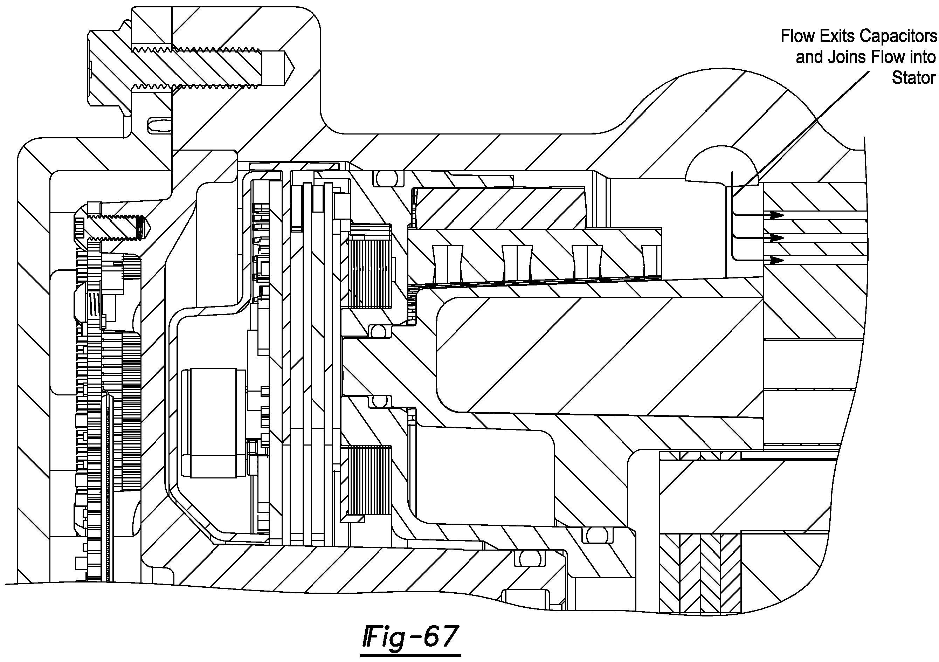

With reference to Figures 45 through 72, another inverter constructed in accordance with the teachings of the present disclosure is generally indicated by reference numeral 204a. Unless expressly described herein, the inverter 204a can be generally similar to the inverter 204 (Fig. 3) described in detail above.

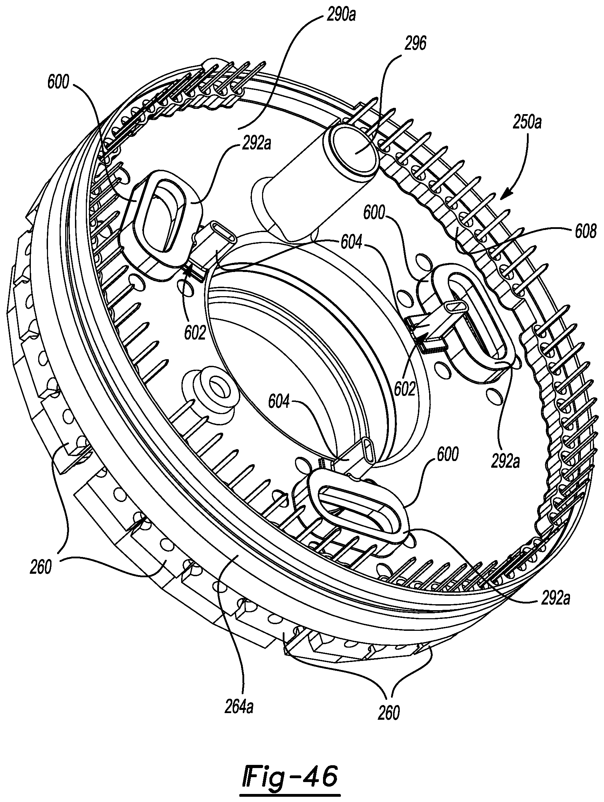

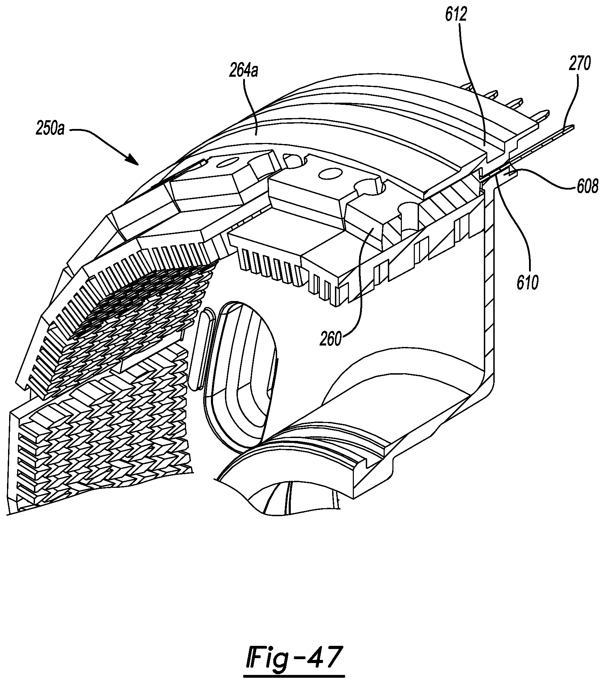

In Figure 46, the transistor assembly 250a has a retaining member 264a that is formed as a discrete component and thereafter various other components, including the surface mount MOSFET's 260, can be assembled to the retaining member 264a. The retaining member 264a defines a plurality of phase lead bosses 292a, a plurality of current sensor lamination mounts 600 and a plurality of sensor mounts 602. Each of the phase lead bosses 292a can be disposed axially through the retaining member 264a and can be disposed within an associated one of the current sensor lamination mounts 600. Each of the phase lead bosses 292a is sized to receive portion of a corresponding phase lead (not shown) that supplies electric power to the electric motor. Each of the current sensor lamination mounts 600 is a generally oval-shaped structure that projects axially from the bottom surface 290a of the retaining member 264a. Each of the sensor mounts 602 is disposed proximate an associated one of the current sensor lamination mounts 600 and defines a hollow, oval-shaped guide tube 604 that projects axially away from the bottom surface 290a of the retaining member 264a. In this example, the retaining member 264a defines a plurality of insulating shields 608 that are spaced about the circumference of the retaining member 264a and which extend axially from the bottom surface 290a of the retaining member 264a. With additional reference to Figure 47, each of the insulating shields 608 is disposed about (e.g., concentrically about) a corresponding aperture 610 that is sized to receive a corresponding terminal from one of the MOSFET's 260. The insulating shields 608 help to electrically insulate the terminals of the MOSFET's 260 from one another.

Figure 47 shows a portion of the transistor assembly 250a and depicts the presence of an annular seal ring groove 612 about the perimeter of the retaining member 264a. The seal ring groove 612 is configured to receive an appropriate elastomeric seal (e.g., an O-ring) therein that sealingly engages the retaining member 264a and the housing assembly 12 (Fig. 1).

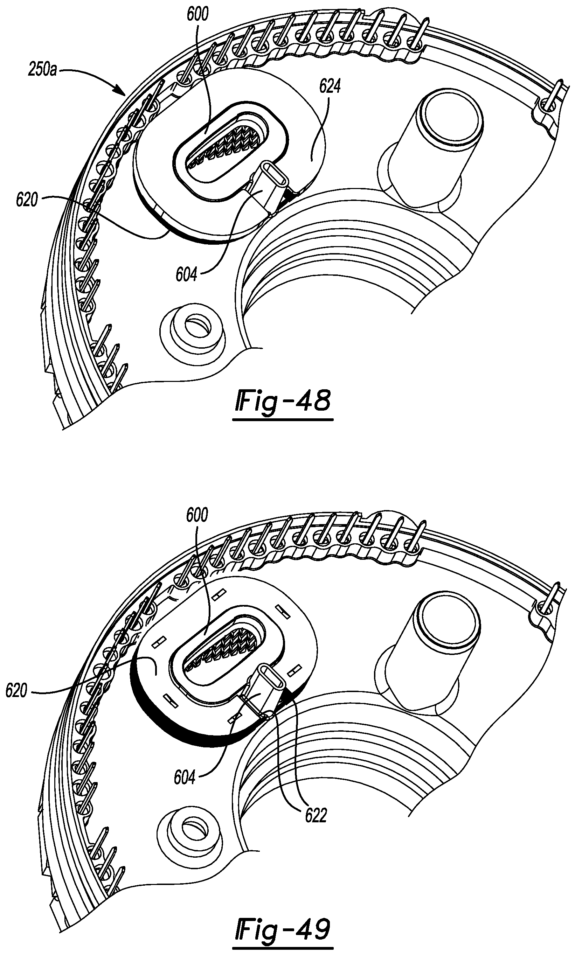

With reference to Figures 48 and 49, a plurality of current sensor laminations 620 are stacked onto each of the current sensor lamination mounts 600. The current sensor laminations 620 are formed of steel and are generally C-shaped so as to define a pair of end faces 622 that are disposed on opposite sides of an associated guide tube 604. The current sensor laminations 620 can be configured with locating features that nest into or with locating features on adjacent ones of the current sensor laminations 620 to help secure the current sensor laminations 620 to one another. A generally C-shaped insulating member 624 can be disposed on each stack of current sensor laminations 620 on an axial side of the stack that is opposite the bottom surface 290a.

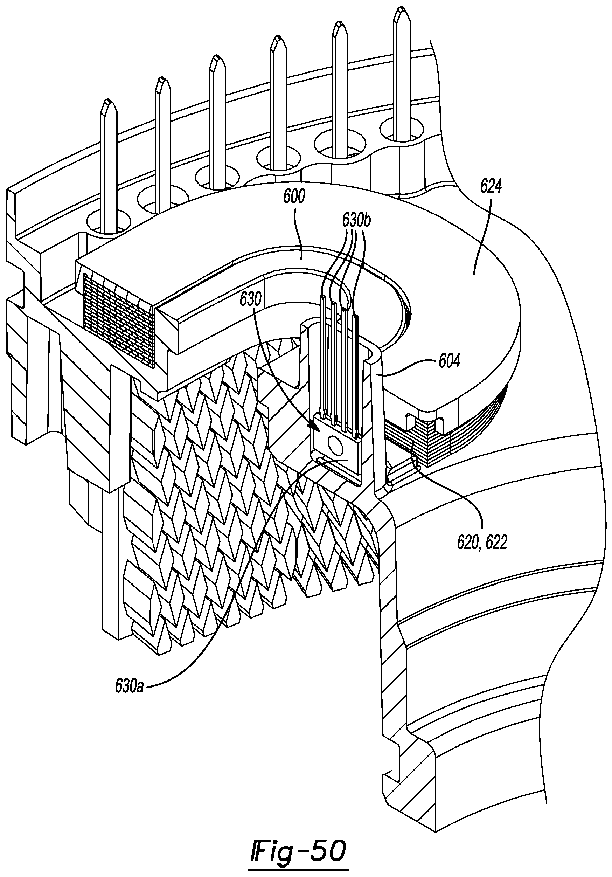

In Figure 50, a Hall sensor 630 is disposed in an associated one of the sensor mounts 602. A proximal end of the Hall sensor 630 is mounted to the circuit board so that the sensor portion 630a of the Hall sensor 630 is disposed parallel to end faces 622 of the current sensor laminations 620 at a desired location along a sensing axis relative to the stack of current sensor laminations 620. Because the sensor portion 630a of the Hall sensor 630 is disposed at some distance from the proximal end of the Hall sensor 630, it will be appreciated that it would be relatively easy to bend the terminals 630b of the Hall sensor 630, which would affect the positing of the sensor portion 630a of the Hall sensor 630. The guide tube 604, however, is sized and located relative to an associated one of the current sensor lamination mounts 600 to receive the sensor portion 630a of the Hall sensor 630 as the circuit board is mounted to the retaining member 264a and the MOSFET's 260 and guide the sensor portion 630a into a desired location between the end faces 622.

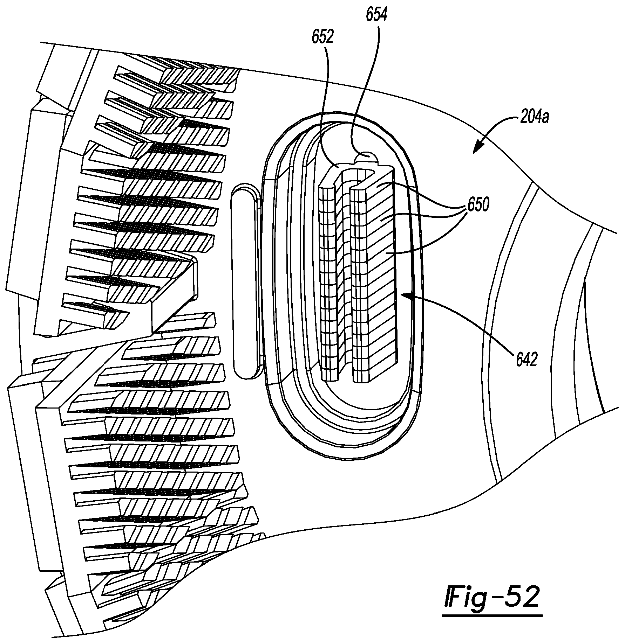

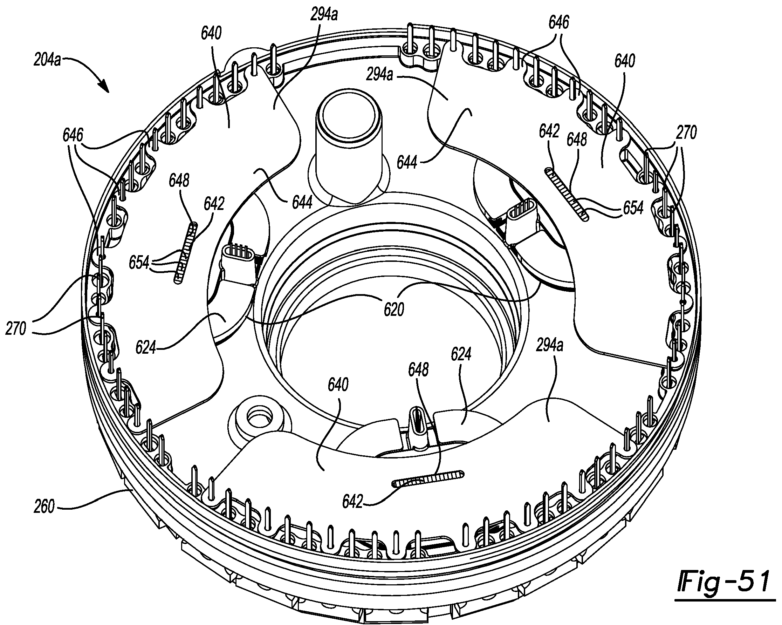

With reference to Figures 51 and 52, each of the phase leads 294a can include a conductor plate 640 and a receiver 642. The conductor plate 640 can be formed of a suitable electrically-conductive material, such as copper. Each conductor plate 640 can have a body 644 and a plurality of protrusions 646 that extend radially outwardly from the body 644. The body 644 can overlie an associated one of the stacks of current sensor laminations 620 and can define a receiver aperture 648 that can be disposed in-line with a corresponding one of the phase lead bosses 292a. It will be appreciated that the insulating member 624 can inhibit the transmission of electricity between the conductor plate 640 and the current sensor laminations 620. Each of the protrusions 646 can define an aperture that is sized to receive a lead 270 of an associated one of the MOSFET's 260.

The receiver 642 is formed of a plurality of individually bident-shaped members 650 that are linearly arranged (i.e., stacked back-to-front) and permanently affixed to the conductor plate 640. Each bident-shaped copper member 650 can be formed of an appropriate electrically conductive material, such as copper, and can have body 652 and a base 654. The body 652 can define a pair of tines and a generally U-shaped opening. Each of the tines can have a protrusion or barb that is fixedly coupled to a distal end of the tine and which extends inwardly therefrom so as to narrow the portion of the generally U-shaped opening that is opposite the base 654. The base 654 is received into the receiver aperture 648 in an associated one of the conductor plates 640. In the example shown, the receiver apertures 648 are formed along a straight line and as such, the bident-shaped members 650 that form the receiver 642 are arranged along the straight line. It will be appreciated, however, that one or more of the receiver apertures 648 could be arranged along a line that is shaped differently (e.g., an arcuate line) and that the associated set of bident-shaped members 650 are similarly arranged along a differently shaped (i.e., non-straight) line.

It will be appreciated that each phase of electric power supplied to the inverter 204a can be electrically coupled to a blade terminal (not shown) that is received into the generally U-shaped openings in the bident-shaped members 650 and electrically coupled to the receiver 642. The individual bident-shaped members 650 permit flexing of the tines relative to one another and ensure that the blade terminal electrically contacts multiple ones of the tines (preferably all or substantially all of the tines) to transmit an associated phase of electric power through the receiver 642 and into the conductor plate 640, which transmits the associated phase of electric power to a set of the MOSFET's 260.

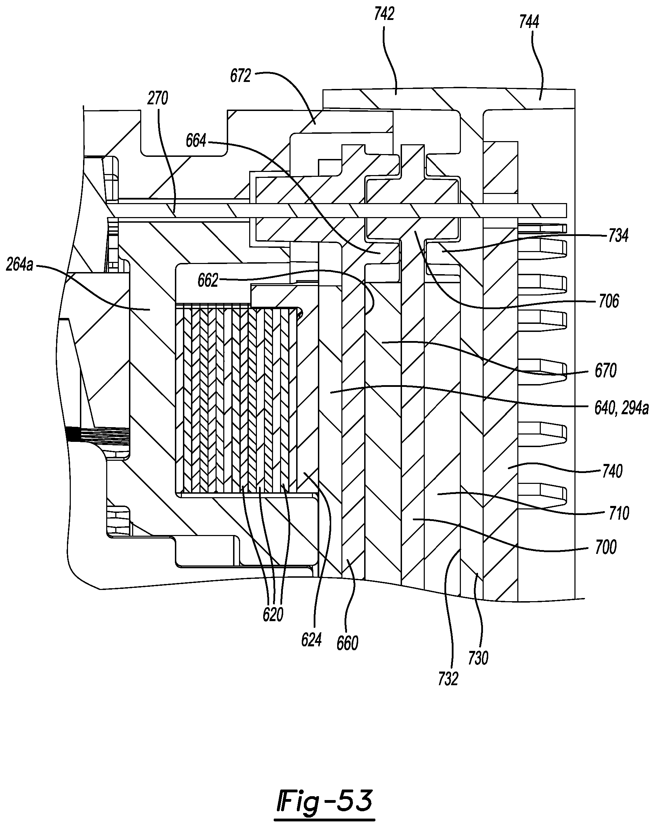

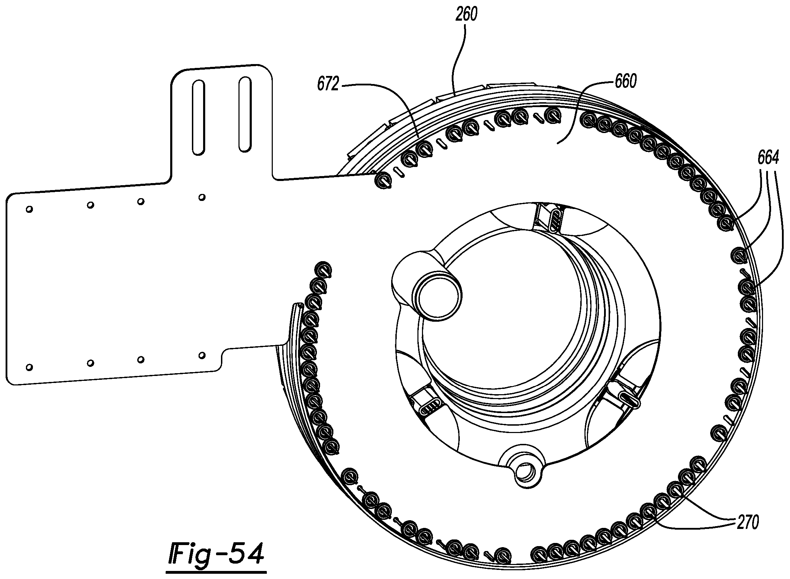

In Figures 53 and 54, a first insulator 660 is abutted against the phase leads 294a on a side of the phase leads that is opposite the generally C-shaped insulating members 624. The first insulator 660 can define a first bus bar recess 662 and a plurality of first insulating collars 664. The first bus bar recess 662 is disposed on an axial side of the first insulator 660 that is opposite the side that abuts the phase leads 294a. Each of the first insulating collars 664 is disposed about a terminal 270 of a respective one of the MOSFET's 260. Each first insulating collars 664 can having a first end, which can be received into a mating recess that is formed in the retaining member 264a. It will be appreciated that the first insulating collars 664 are disposed about terminals 270 of the MOSFET's 260 that need be electrically separated from a first bus bar 670 that is received into the first bus bar recess 662. Holes are formed through the first insulator 660 to receive therethrough any electric terminals (e.g., the terminals 270 of the MOSFET's 260) that need extend through the first insulator 660. Each of the first insulating collars 664 can be disposed concentrically about a respective one of the holes.

In the example shown the retaining member 264a defines a flange 672, which is disposed circumferentially about the terminals 270 of the MOSFET's 260.

With reference to Figures 53, 55 and 56, the first bus bar 670 is abutted to the first insulator 660 and received into the first bus bar recess 662. The first bus bar 670 has an annular bar body 676, a plurality of protrusions 678 that extend radially outwardly from the annular bar body 678, and a power input portion 680. Each of the protrusions 678 is sized to be received between the first insulating collars 664 of the first insulator 660 and to be electrically coupled to a respective one of the terminals 270 of the MOSFET's 260. Holes are formed through the protrusions and the power input portion 680 to receive terminals 270 from the MOSFET's 260 and from the terminals 684 of a pair of capacitors 686, respectively. A first slotted aperture 690 is formed in the power input portion 680 to receive a blade terminal 692 that electrically couples the first bus bar 670 to a source of electrical power (not shown).

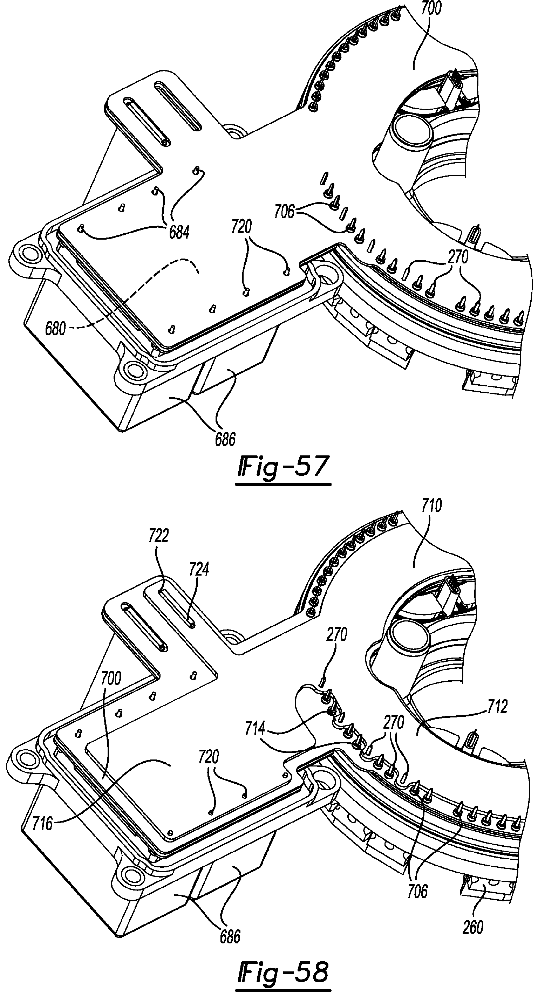

With reference to Figures 53 and 57, a second insulator 700 can be mounted to the first bus bar 670 on a side opposite the first insulator 660. Like the first insulator 660, the second insulator 700 can extend over the power input portion 680, can have a plurality of holes for receipt of various terminals 270 and 684 therethrough and can define a plurality of (second) insulating collars 706 that can be disposed about the terminals 270 of the MOSFET's 260 to electrically separate those terminals 270 of the MOSFET's 260 that will not be electrically coupled a second bus bar 710. Each of the second insulating collars 706 can define a pair of hollow, tubular projections that can project in opposite axial directions. The tubular projections on the side of the second insulator 700 that face toward the first insulator 660 can be matingly received into recesses that are defined by the first insulating collars 664.

With reference to Figures 53 and 58, the second bus bar 710 is abutted to the second insulator 700. The second bus bar 710 has an annular bar body 712, a plurality of protrusions 714 that extend radially outwardly from the annular bar body 712 and a power input portion 716. Each of the protrusions 714 is sized to be received between the second insulating collars 706 of the second insulator 700 and to be electrically coupled to a respective one of the terminals 270 of the MOSFET's 260. Holes are formed through the protrusions 714 and the power input portion 716 to receive terminals 270 from the MOSFET's 260 and from the terminals 720 of the pair of capacitors 686, respectively. A second slotted aperture 722 is formed in the power input portion 716 to receive a blade terminal 724 that electrically couples the second bus bar 710 to a source of electrical power (not shown)

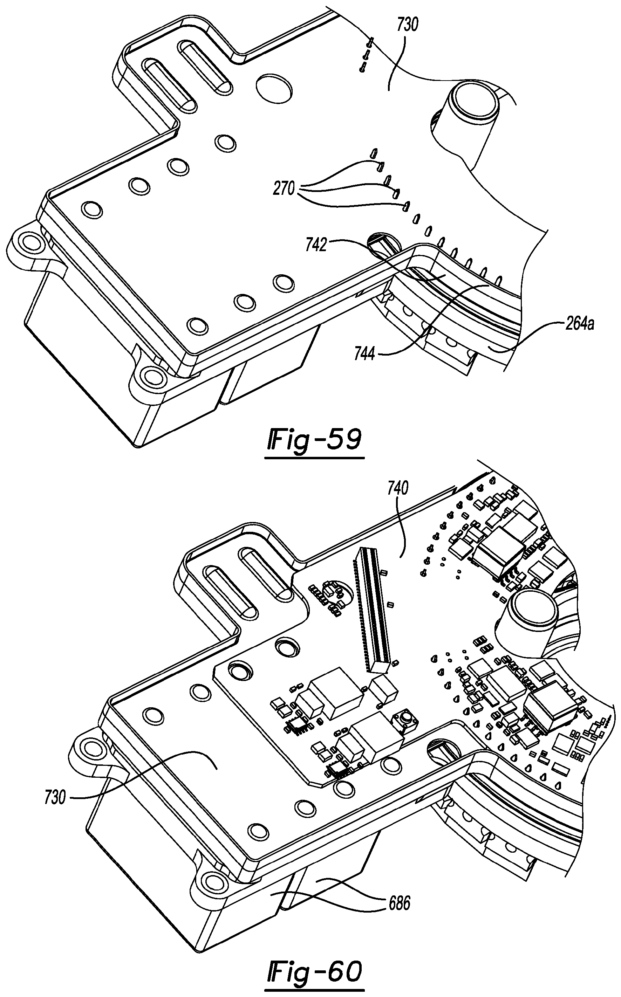

With reference to Figures 53 and 59, a third insulator 730 is mounted to the retaining member 264a and abuts the second bus bar 710 on a side opposite the second insulator 700. The third insulator 730 defines a second bus bar recess 732 into which the second bus bar 710 is received. The third insulator 730 also defines a plurality of third insulating collars 734 and a plurality of holes. Each of the third insulating collars 734 can define a recess that can receive a tubular projection from an associated one of the second insulating collars 706 of the second insulator 700. The holes can extend through the third insulator 730 to receive there through various terminals, such as the terminals 270 of the MOSFET's 260, so that those terminals can be electrically coupled to the circuit board 740. The third insulator 730 can define first and second flange members 742 and 744, respectively, that can extend axially from a central body of the third insulator 730 in opposite axial directions. Each of the second and third flange members 742 and 744 is disposed about the perimeter of the central body of the third insulator 730. The flange 672 of the retaining member 264a can be received within (and optionally can abut) the second flange member 742 to form a labyrinth about a cavity that is defined by the retaining member 264a and the third insulator 730.

In Figures 53 and 60, the circuit board 740 can be abutted to the third insulator 730 on a side opposite the second bus bar 710 and can be electrically coupled to the various terminals that extend through the third insulator 730.

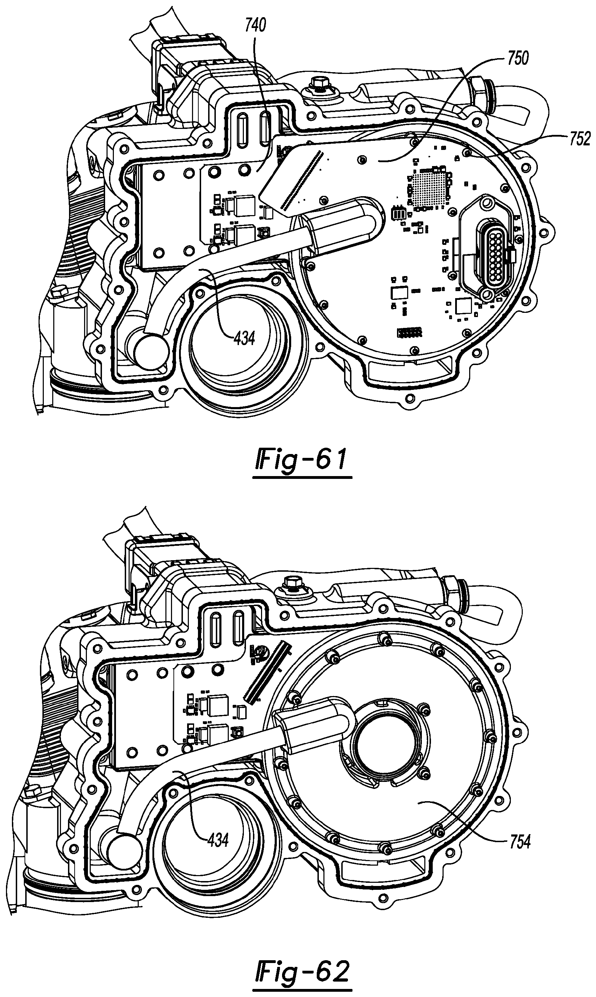

In Figures 61 through 63 a control board 750 is plugged into the circuit board 740 and is fixedly coupled threreto via a plurality of threaded fasteners 752. The control board 750 is disposed about the transfer tube 434 that is mounted to a bearing support 754 that holds a bearing 756 that supports a rotor shaft 38 of the electric motor relative to the housing of the electric motor. The transfer tube 434 is sealingly engaged to the oil inlet port 296 that is unitarily and integrally formed with the retaining member 264a (Fig. 46). Coolant received by the oil inlet port 296 in the retaining member is employed to route cooling liquid to the inverter 204a and to the electric motor.

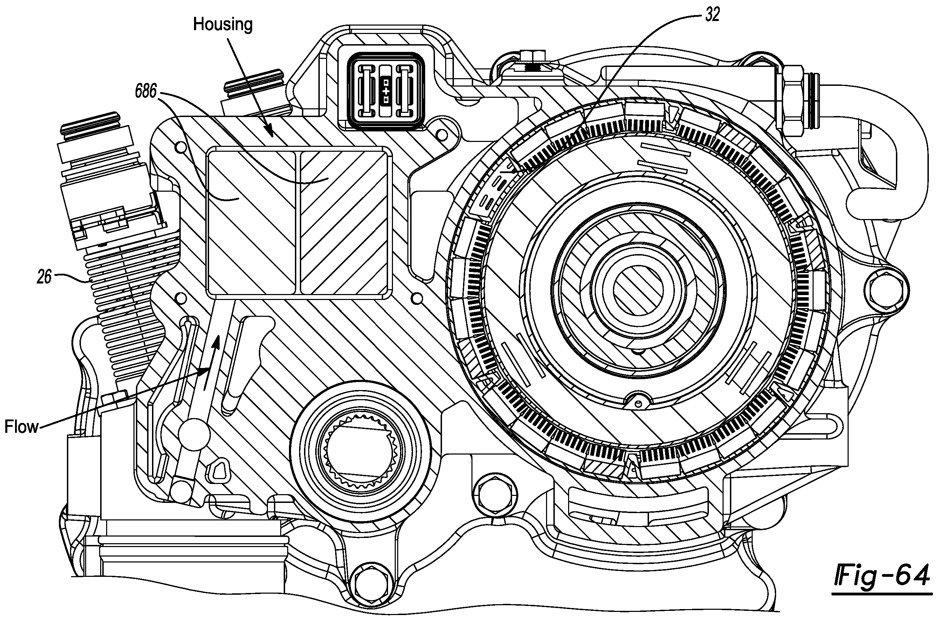

In Figures 64 through 67, a portion of the flow of the filtered coolant that is discharged from the heat exchanger 26 is routed to the capacitors 686 to cool the capacitors 686. Coolant discharged from the capacitors 686 is routed to join the flow of cooling liquid enters the stator 32 to cool the electric motor.

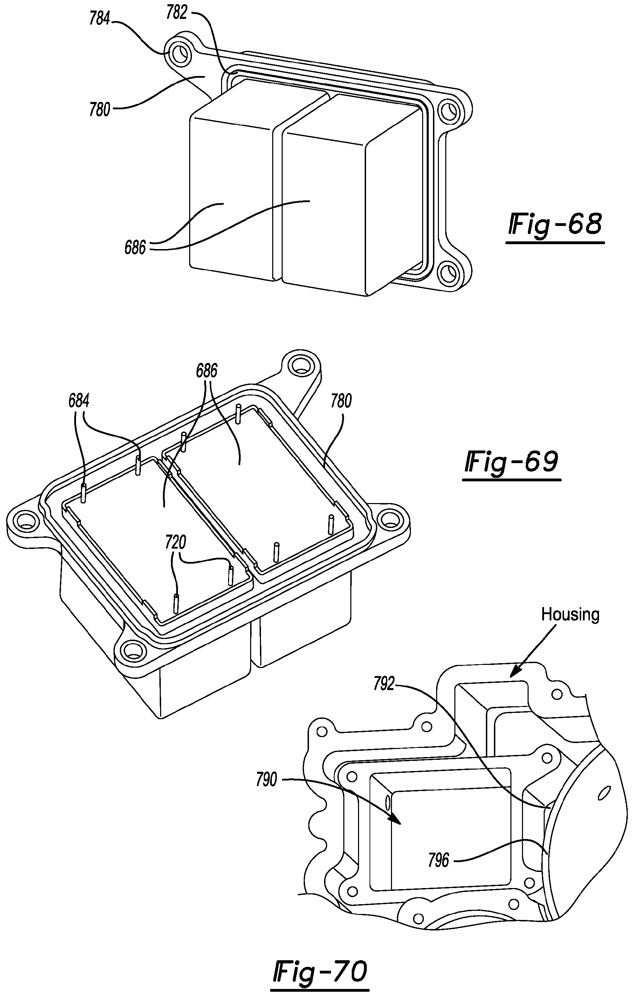

The capacitors 686 are illustrated in Figure 68 as being mounted to a tray 780 that holds a seal member 782. Optional crush limiters 784 can be mounted to the tray 780 to limit the amount by which the seal member 782 is compressed. Figure 69 depicts the reverse side of the tray 780 and the terminals 684, 720 of the capacitors 686. The capacitors 686 can be potted to the tray 780 with a suitable compound to form a seal between the capacitors 686 and the tray 780.

Figure 70 depicts a recess 790 in the housing that is configured to receive the tray 780 (Fig. 68) and the capacitors 686 (Fig. 68). A gallery 792 that is integrally formed with the housing permits cooling fluid in the recess 790 to be discharged through a housing wall 796 to the stator 32 (Fig. 64) of the electric motor.

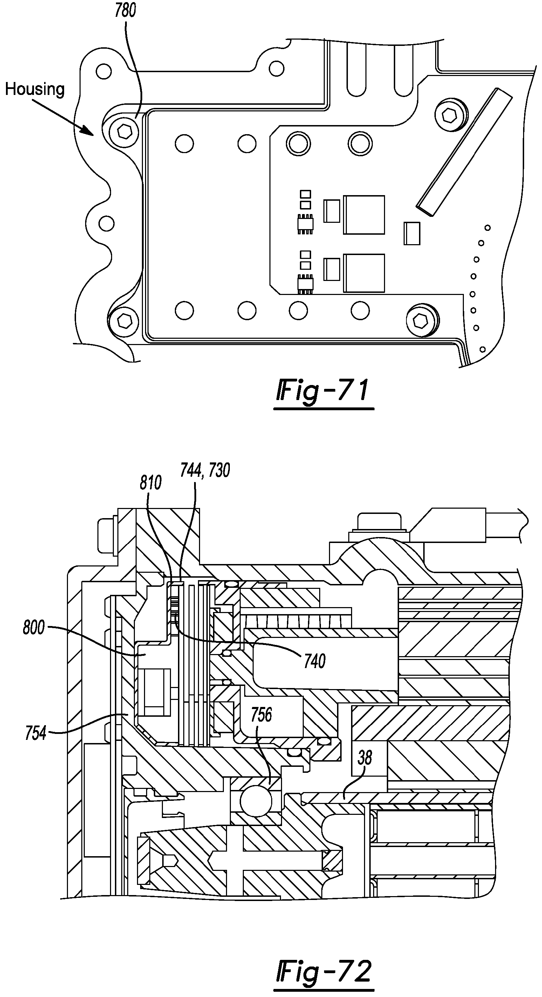

Figure 71 depicts the tray 780 being mounted to the housing via a plurality of threaded fasteners.

Figure 72 depicts a fourth insulator 800 that is disposed between the circuit board 740 and the bearing support 754. The fourth insulator 800 can have a flange 810 about its perimeter that can be received into the third flange 744 on the third insulator 730 to form a labyrinth between the third and fourth insulators 730 and 800.

The foregoing description of the embodiments has been provided for purposes of illustration and description. It is not intended to be exhaustive or to limit the disclosure. Individual elements or features of a particular embodiment are generally not limited to that particular embodiment, but, where applicable, are interchangeable and can be used in a selected embodiment, even if not specifically shown or described. The same may also be varied in many ways. Such variations are not to be regarded as a departure from the disclosure, and all such modifications are intended to be included within the scope of the disclosure.

Some illustrative embodiments are described herein in the following CLAUSES:
CLAUSE 1. A motor assembly comprising:
   an inverter (204) having a plurality of transistor assemblies (250), each of the transistor assemblies including a surface mount MOSFET (260), a heat sink (262) and a solder material, the MOSFET having a plurality of blade terminals (270a, 270b, 270c) and a surface mount terminal that is electrically coupled to one of the blade terminals, the heat sink having a base (280) and a plurality of fins (282) that extend from the base, the base defining a pocket (288) having a bottom surface (290), wherein the MOSFET is received into the pocket such that the surface mount terminal is disposed proximate the bottom surface, the solder material thermally coupling the surface mount power terminal to the heat sink.
CLAUSE 2. The motor assembly of CLAUSE 1, wherein the invertor further comprises a retainer (264) that fixedly couples the MOSFETS and the heat sinks to one another.
CLAUSE 3. The motor assembly of CLAUSE 2, wherein the retainer is cohesively bonded to the MOSFETS and the heat sinks.
CLAUSE 4. The motor assembly of CLAUSE 2, wherein the solder material has a melting point that is low enough to permit the solder material to melt when the motor assembly is operated at a predetermined power load for a predetermined time interval.
CLAUSE 5. The motor assembly of CLAUSE 4, wherein the retainer forms a seal between each of the MOSFETS and each of the heat sinks that inhibits migration of the solder material out of the pocket when the solder material melts.
CLAUSE 6. The motor assembly of CLAUSE 1, wherein the solder material comprises indium.
CLAUSE 7. The motor assembly of CLAUSE 1, wherein one of the MOSFET and the heat sink is formed with a feature (292) that provides clearance between the MOSFET and the heat sink to permit air to vent from between the surface mount power terminal and the bottom surface.
CLAUSE 8. The motor assembly of CLAUSE 7, wherein the feature comprises a tapered wall on the heat sink that defines at least a portion of the pocket.
CLAUSE 9. A method for mitigating solder fatigue in an inverter (204) of an electric motor, the method comprising:
   providing a surface mount MOSFET (260) having a plurality of blade terminals (270a, 270b, 270c) and a surface mount terminal that is electrically coupled to one of the blade terminals;
   providing a heat sink (262) having a base (280) and a plurality of fins (282) that extend from the base, the base defining a pocket (288) having a bottom surface (290); placing a solder material adjacent the bottom surface;
   placing the MOSFET into the pocket such that the solder material is disposed between the surface mount power terminal and the bottom surface;
   melting the solder material to bond the surface mount power terminal to the heat sink;
   operating the motor assembly to generate heat in the inverter that is sufficient to cause the solder material to melt; and
   cooling the solder material to cause the solder material to re-bond to the surface mount power terminal to the heat sink.
CLAUSE 10. A motor assembly comprising:
   a stator (32) having a plurality of field windings (36);
   a rotor (34) received in the stator and rotatable about a rotary axis;
   a control unit (16) having an inverter (204) and a controller (206), the inverter being electrically coupled to the field windings, the controller comprising a circuit board assembly and a magnet (302), the circuit board assembly being coupled to the stator and having a tunnel magneto resistive (TMR) sensor (300) that is configured to sense a rotational position of the magnet about the rotary axis and responsively generate a sensor signal, the controller being configured to control the inverter to power the field windings responsive to the sensor signal.
CLAUSE 11. An electric drive unit comprising:
   a stator (32) having a stator body and a plurality of field windings (36), the stator body defining a plurality of cooling channels that extend longitudinally through the stator body, the field windings being fixedly coupled to the stator body and being circumferentially spaced apart about a central longitudinal axis; and
   an inverter assembly that includes a plurality of MOSFET's (260), a plurality of heat sinks (262) and an end plate (290), each of the MOSFET's being thermally coupled to a corresponding one of the heat sinks, each of the heat sinks having a plurality of fins (262) that extend into a flow channel that is coaxial with the field windings and disposed radially between the field windings and the MOSFET's, the end plate being fixedly coupled to the MOSFET's and having a tubular central projection (442) and a coolant inlet port (296), the tubular central projection being sealingly coupled to the field windings (36) such that an annular cavity (440) is formed radially between a radially outer surface of the tubular central projection and an interior circumferential surface of the field windings, the coolant inlet port intersecting the annular cavity, wherein an annular gap (448) is formed axially between the end plate and an axial end of the field windings, a radially inward end of the annular gap intersecting the annular cavity, a radially outward end of the annular gap intersecting the flow channel. CLAUSE 12. An electric drive module comprising:
      a housing assembly having a first housing and a second housing;
      a differential assembly received in the first housing, the differential assembly having a differential case that is rotatable about a differential axis;
      a differential bearing received in the first housing and supporting the differential case for rotation relative to the housing assembly;
      a stator received in the second housing, the stator defining a plurality of cooling channels that are formed longitudinally through the stator;
      a rotor received in the stator and rotatable about a rotor axis;
      wherein a lubrication gallery (464) is formed into an axial end of one of the first and second housings, the lubrication gallery having a first end, which is in fluid communication with the cooling channels in the stator, and a second end that is in fluid communication with the differential bearing.
CLAUSE 13. The electric drive module of CLAUSE 12, further comprising an output shaft (90), wherein the differential assembly comprises a gearset with a side gear, wherein the output shaft is coupled to the side gear for rotation therewith, and wherein lubrication exiting the second end of the lubrication gallery is configured to drain onto the output shaft, wherein a first portion of the lubricant that drains onto the output shaft is directed toward the side gear to lubricate the gearset, and wherein a second portion of the lubricant that drains onto the output shaft is directed away from the side gear toward a shaft bearing (94) that supports the output shaft relative to the housing assembly for rotation about the differential axis.
CLAUSE 14. An electric drive module comprising:
   a motor having a stator and a rotor that is rotatably disposed in the stator for rotation about a rotary axis, the stator having a plurality of field windings that are spaced circumferentially about the rotary axis; and
   an inverter having a circuit board assembly, a plurality of MOSFET's and a plurality of heat sinks, the circuit board assembly having a circuit board, which has an annular portion that is disposed concentrically about the rotor, and a plurality of power terminals, each of the MOSFET's having a plurality of terminals that are received through and electrically coupled to the circuit board assembly, the MOSFET's being disposed in a circular arrangement, each of the heat sinks being thermally coupled to an associated one of the MOSFET's, the heat sinks being disposed concentrically within the MOSFET's.
CLAUSE 15. The electric drive unit of CLAUSE 14, wherein the inverter includes a retainer that is coupled to the MOSFET's and disposed concentrically about the MOSFET's.
CLAUSE 16. The electric drive module of CLAUSE 15, further comprising an end plate (290) that is coupled to the MOSFET's and the heat sinks, the end plate being disposed axially between the heat sinks and the circuit board assembly.
CLAUSE 17. The electric drive module of CLAUSE 16, further comprising a plurality of phase leads, wherein the end plate defines a plurality of phase lead bosses and each of the phase leads is received through an associated one of the phase lead bosses and is electrically coupled to an associated set of the field windings.
CLAUSE 18. The electric drive module of CLAUSE 16, wherein the end plate has a tubular central projection (442) that is sealingly engaged to the field windings (36).
CLAUSE 19. The electric drive module of CLAUSE 15, further comprising a housing (12), wherein the motor and inverter are received in the housing, and wherein the retainer is sealingly engaged to the housing.
CLAUSE 20. The electric drive module of CLAUSE 15, wherein the retainer is cohesively bonded to the MOSFET's.
CLAUSE 21. The electric drive module of CLAUSE 14, further comprising a field capacitor, a first bus bar, a second bus bar, a first insulator, a second insulator, a third insulator, and a plurality of conductor plates, the field capacitor having a set of first capacitor leads and a set of second capacitor leads, the first bus bar being electrically coupled to the first set of capacitor leads and having a first annular portion that is concentric with the circuit board, the first bus bar being electrically coupled to a terminal on each of a first powering set of the MOSFET's, the second bus bar being electrically coupled to the second set of capacitor leads and having a second annular portion that is concentric with the circuit board, the second bus bar being electrically coupled to a terminal on each of a second powering set of the MOSFET's, the first insulator being disposed between the conductor plates and the first bus bar, the second insulator being disposed between the first and second bus bars, the third insulator being disposed between the circuit board and the second bus bar, each of the conductor plates being electrically coupled to a power output terminal on each of a plurality of the MOSFET's that control power to an associated set of the field windings.
CLAUSE 22. The electric drive unit of CLAUSE 21, further comprising a plurality of receivers, each of the receivers being electrically coupled to an associated one of the conductor plates, each of the receivers being formed of a plurality of bident-shaped conductive members that have a pair of tines that cooperate to form an opening, and wherein each set of the field windings has a blade terminal that is received in the opening and engaged to the tines of the bident-shaped conductive members of an associated one of the receivers.
CLAUSE 23. The electric drive unit of CLAUSE 21, further comprising a plurality of current sensors, each of the current sensors having a plurality of current sensor laminations, which are disposed proximate a corresponding one of the conductor plates, and a Hall-effect sensor that is electrically coupled to the circuit board assembly and configured to sense a magnetic field in the plurality of current sensor laminations.
CLAUSE 24. The electric drive unit of CLAUSE 23, wherein each of the current sensor laminations is C-shaped having a pair of opposing end faces, wherein the first insulator defines a plurality of current sensor lamination mounts and a plurality of sensor mounts, each of the current sensor lamination mounts being configured to receive the current sensor laminations of a corresponding one of the current sensors thereon such that the opposing end faces are disposed on opposite sides of the sensor mount, and wherein the sensor mount is disposed between the opposing end faces, and wherein the Hall-effect sensor is disposed on the sensor mount.
CLAUSE 25. The electric drive unit of CLAUSE 24, wherein the first insulator defines a plurality of guide tubes, each of the guide tubes being disposed about a corresponding one of the sensor mounts and shrouding a set of terminals of an associated one of the Hall-effect sensors.
CLAUSE 26. The electric drive unit of CLAUSE 24, further comprising a plurality of insulating members, each of the insulating members being disposed between the current sensor laminations of one of the current sensors and a corresponding one of the conductor plates.
CLAUSE 27. An electric drive module comprising:
   a housing defining a pump mount (310);
   a motor received in the housing, the motor having a stator, a rotor and an inverter, the stator having a plurality of windings that are disposed circumferentially about a first axis, the stator defining a plurality of coolant passages (450) that extend longitudinally through the stator, the rotor being received in the stator and being rotatable about the first axis, the inverter having a plurality of MOSFET's, a plurality of heat sinks and an end plate, the heat sinks being disposed concentrically about the field windings, each of the MOSFET's being
   thermally coupled to an associated one of the heat sinks, the end plate being coupled to the MOSFET's and the heat sinks and being offset in an axial direction along the first axis from the field windings to form a first flow channel between an axial end of the field windings and the end plate;
   a transmission received in the housing, the transmission having an input gear, which is driven by the rotor for rotation about the first axis, and an output gear that is rotatable about a second axis that is parallel to the first axis;
   a differential assembly received in the housing, the differential assembly having a differential input, which is coupled to the output gear for rotation about the second axis, and a pair of differential output members;
   a pair of shafts, each of the shafts being coupled to an associated one of the differential output members for rotation therewith;
   an oil pump (24) mounted to the pump mount;
   wherein oil pump provides a flow of pressurized oil, wherein a first portion of the flow of oil is routed through the first flow channel, and travels through the heat sinks and the coolant passages to cool the inverter and the stator, wherein a second portion of the flow of oil is routed through the rotor to cool the rotor.
CLAUSE 28. The electric drive module of CLAUSE 27, further comprising a heat exchanger (26) and an oil filter (28), wherein the housing defines a heat exchanger base (312) and a filter mount (314), wherein the heat exchanger (26) is mounted to the heat exchanger base and wherein the oil filter (28) is mounted to the filter mount (314).
CLAUSE 29. The electric drive unit of CLAUSE 28, wherein the entirety of the flow of pressurized oil flows through the heat exchanger.
CLAUSE 30. The electric drive unit of CLAUSE 28, wherein the entirety of the flow of pressurized oil flows through the oil filter.
CLAUSE 31. The electric drive unit of CLAUSE 28, further comprising a differential bearing that supports the differential input for rotation about the second axis relative to the housing, the differential bearing being in fluid communication with outlets of the coolant passages in the stator.
CLAUSE 32. The electric drive unit of CLAUSE 31, wherein the differential assembly comprises a differential gearset that is in fluid communication with the differential bearing.
CLAUSE 33. The electric drive unit of CLAUSE 31, further comprising a shaft bearing that supports one of the shafts for rotation about the second axis relative to the housing, wherein the shaft bearing is in fluid communication with the differential bearing.
CLAUSE 34. The electric drive unit of CLAUSE 28, further comprising a rotor bearing that supports the rotor for rotation about the first axis relative to the housing, the rotor bearing being in fluid communication with outlets of the coolant passages in the stator.
CLAUSE 35. The electric drive unit of CLAUSE 28, wherein the housing includes a feed pipe that fluidly couples a central coolant passage in the rotor to the oil pump.
CLAUSE 36. The electric drive unit of CLAUSE 35, wherein the feed pipe extends through the input gear of the transmission.
CLAUSE 37. The electric drive unit of CLAUSE 36, wherein at least a portion of the oil that exits the central coolant passage in the rotor is re-directed to flow concentrically about the central coolant passage toward the feed pipe.
CLAUSE 38. The electric drive unit of CLAUSE 37, wherein the oil that exits the rotor concentrically about the central coolant passage is directed to lubricate a plurality of gears of the transmission and a plurality of bearings that support the gears of the transmission for rotation about respective gear axes.
CLAUSE 39. The electric drive module of CLAUSE 37, wherein a portion of the oil that exits the central coolant passage is routed to lubricate a rotor bearing that supports the rotor for rotation relative to the housing.
CLAUSE 40. The electric drive module of CLAUSE 28, wherein the inverter includes a circuit board assembly, which is electrically coupled to the MOSFET's, and a field capacitor that is electrically coupled to the circuit board assembly, wherein the housing defines a field capacitor cavity that houses the field capacitor cavity, and wherein the field capacitor cavity is coupled in fluid communication with the oil pump. CLAUSE 41. The electric drive unit of CLAUSE 40, wherein the field capacitor cavity is in fluid communication with the coolant passages in the stator.
CLAUSE 42. The electric drive unit of CLAUSE 41, wherein oil exiting the field capacitor cavity mixes with the oil that is exiting through the heat sinks in the inverter prior to entering into the coolant passages in the stator.
CLAUSE 43. The electric drive unit of CLAUSE 28, wherein the housing includes a bearing support that is disposed concentrically about the rotor, and wherein a rotor bearing is mounted on the bearing support and the bearing support, the rotor bearing supporting the rotor for rotation about the first axis relative to the housing.
CLAUSE 44. The electric drive unit of CLAUSE 43, wherein the inverter includes a circuit board assembly that is electrically coupled to the MOSFET's, wherein the circuit board assembly has an annular configuration that is mounted about a portion of the bearing support on which the rotor bearing is mounted.
CLAUSE 45. The electric drive module of CLAUSE 44, wherein an electric insulator is disposed between the circuit board assembly and the bearing support.

## Claims

1. An electric drive unit comprising:
a stator (32) having a stator body and a plurality of sets of field windings (36), the stator body defining a plurality of cooling channels (450) that extend longitudinally through the stator body, each of the sets of field windings (36) being fixedly coupled to the stator body and being circumferentially spaced apart about a central longitudinal axis;
a rotor (34) received in the stator (30) and rotatable about the central longitudinal axis; and
an inverter assembly that includes a plurality of MOSFETs (260), a plurality of heat sinks (262) and an end plate (290), each of the MOSFETs (260) being thermally coupled to a corresponding one of the heat sinks (262), each of the heat sinks (262) having a plurality of fins (282) that extend into a flow channel that is coaxial with the plurality of sets of field windings (36), the end plate (290) being fixedly coupled to the MOSFETs (260) and having a projection (442) and a coolant inlet port (296), the projection (442) being sealingly coupled to the plurality of sets of field windings (36) and defining an annular cavity (440) between a radially outer surface of the projection (442) and an interior circumferential surface of the field windings (36), the coolant port (296) being coupled in fluid communication with the annular cavity (440), wherein the flow channel is in fluid communication with and disposed in a flow path between the annular cavity (440) and the cooling channels (450) in the stator body.

2. The electric drive unit of claim 1, wherein the flow channel is disposed radially between the plurality of sets of field windings (36) and the MOSFETs (260).

3. The electric drive unit of claim 1, wherein the flow channel is disposed radially outwardly of the plurality of sets of field windings (36).

4. The electric drive unit of claim 1, wherein an annular gap (448) is formed axially between the end plate (290) and an axial end of the field windings (36), the annular gap (448) fluidly coupling the annular cavity (440) and the flow channel.

5. The electric drive unit of claim 4, wherein a radially inward end of the annular gap (448) intersects the annular cavity (440), and a radially outward end of the annular gap (448) intersects the flow channel.

6. The electric drive unit of claim 1, wherein the tubular projection (442) carries a seal member that is sealingly mounted to the stator (30).

7. The electric drive unit of claim 1, wherein the inverter assembly further comprises first and second bus bars (670, 710), each of the first and second bus bars (670, 710) having an annular bar body (676, 712) that is electrically coupled to at least a portion of the MOSFETs (260).

8. The electric drive unit of claim 7, wherein the inverter assembly further comprises a plurality of conductor plates (640), each of the conductor plates (640) being electrically coupled to a corresponding set of the MOSFETs (260) and to a phase lead (294a) of a corresponding one of the sets of field windings (36).

9. The electric drive unit of claim 8, wherein the inverter assembly further comprises a current sensor lamination mount (600), a sensor mount (602), a plurality of generally C-shaped sensor laminations (620) and a Hall-effect sensor, the current sensor lamination mount (600) being coupled to the end plate (290), the sensor mount (602) being a tubular structure that projects from the current sensor lamination mount (600), the generally C-shaped current sensor laminations (620) being disposed on the current sensor lamination mount (600) and having open ends that are disposed on opposite sides of the sensor mount (602), the Hall-effect sensor being received in the sensor mount (602) and disposed between the opposite open ends of the generally C-shaped current sensor laminations (620), wherein the generally C-shaped current sensor laminations (620) are received about a portion of one of the phase leads (294a).

10. The electric drive unit of claim 8, wherein each of the phase leads (294a) comprises a receiver (642) that defines a slotted aperture.

11. The electric drive unit of claim 10, wherein the receiver (642) comprises a plurality of individually bident-shaped members (650).

12. The electric drive unit of claim 1, further comprising a transmission (18) having a transmission input gear that is coupled to the rotor (34) for rotation therewith.

13. The electric drive unit of claim 12, further comprising a differential assembly (20) having a differential input member, which is driven by a transmission output gear (46) of the transmission (18), and a pair of differential output members.

14. The electric drive unit of claim 13, wherein the differential input member is a differential case (472) and wherein the differential output member is fixedly coupled to the differential case (472).

15. The electric drive unit of claim 1, wherein the inverter assembly further comprises a TMR sensor (300), wherein a magnet (302) is coupled to the rotor (34) for rotation therewith, and wherein the TMR sensor (300) senses a rotational position of magnet.
